# EUROPEAN PATENT APPLICATION

(11) **EP 4 761 523 A1**
(43) Date of publication of application: **17.06.2026**
(21) Application number: 25177450.1
(22) Date of filing: 19.05.2025
(51) Int. Cl.: H10F 19/90, H10F 77/20

(54) **BACK-CONTACT PHOTOVOLTAIC MODULE**

(30) Priority: 12.12.2024 CN 202411834021; 12.12.2024 CN 202411833841
(71) Applicant: JINKO SOLAR CO., LTD., Shangrao, Jiangxi 334100 (CN); Jinko Solar (Haining) Co., Ltd., Haining City, Zhejiang (CN)
(72) Inventor: TAO, Wusong, Shangrao, Jiangxi 334100 (CN); WANG, Luchuang, Shangrao, Jiangxi 334100 (CN); PENG, Yingying, Shangrao, Jiangxi 334100 (CN); FANG, Sheng, Shangrao, Jiangxi 334100 (CN)
(74) Representative: Balder IP Law, S.L.

(57) **Abstract**

Provided is a back-contact photovoltaic module. The back-contact photovoltaic module includes a cell substrate, a plurality of conductive blocks, and insulating members. Busbars and fingers are arranged on a back surface of the cell substrate, the busbars include first busbars and second busbars alternatingly arranged along a second direction, and the fingers include first fingers and second fingers alternatingly arranged along a first direction. Each of the first finger and second finger includes a plurality of disconnected sections. A respective conductive block is disposed at a disconnected position of a respective first finger and connected to a second busbar, or is disposed at a disconnected position of a respective second finger and connected to a respective first busbar. The insulating members extend along the second direction. At least two insulating members are respectively disposed on two opposing sides of the conductive block.

## Description

### TECHNICAL FIELD

Embodiments of the present disclosure relate to the field of photovoltaic technologies, and in particular, to a back-contact photovoltaic module.

### BACKGROUND

At present, with gradual depletion of fossil energy, photovoltaic cells are being increasingly used as a new energy alternative. A photovoltaic cell is a device that converts light energy of the sun into electrical energy. Photovoltaic cells generate carriers based on the photovoltaic principle, which are then extracted using electrodes to facilitate efficient use of electrical energy. Fingers of a photovoltaic cell play a crucial role in collecting and transmitting electrons. When a plurality of solar cells are assembled into a photovoltaic module, interconnecting members are typically used to connect fingers of adjacent cells.

In a back-contact photovoltaic module, busbars collect currents from fingers. Conductive blocks are arranged on the busbars, and the interconnecting members establish electrical connections to the busbars through these conductive blocks to collect currents from the busbars. Since the interconnecting members and the fingers are arranged in different directions, the interconnecting members need to not only connect fingers of the same polarity but also span across fingers of different polarities. To prevent short circuits caused by connection of the interconnecting members to the fingers of different polarities, insulating members need to be designed on the fingers with a polarity different from that of the interconnecting members.

However, the design of the insulating members not only affects a stress exerted on the cell due to the connection of the interconnecting members to the conductive blocks, but also impacts electrical conductivity of the fingers adjacent to the conductive blocks. For example, an improper design may lead to excessive bending of the interconnecting members, severe warping of cells, localized fracture of some of the busbars or fingers, and the like. These issues may ultimately adversely affect structural stability of the back-contact photovoltaic module.

### SUMMARY

Embodiments of the present disclosure provide a back-contact photovoltaic module, which is at least favorable to improving structural stability of the back-contact photovoltaic module.

According to some embodiments, one aspect of embodiments of the present disclosure provides a back-contact photovoltaic module. The back-contact photovoltaic module includes a cell substrate, a plurality of busbars and a plurality of fingers, a plurality of conductive blocks, and insulating members. The plurality of busbars and the plurality of fingers are arranged on the cell substrate, the plurality of fingers include first fingers and second fingers alternatingly arranged along a first direction, and the plurality of busbars include first busbars and second busbars alternatingly arranged along a second direction. Each of the first fingers and second fingers includes a plurality of disconnected sections, each first busbar of at least some of the first busbars is between respective two adjacent disconnected sections of each of the second fingers, and each second busbar of at least some of the second busbars is between respective two adjacent disconnected sections of each of the first fingers. A respective conductive block of the plurality of conductive blocks is disposed between two adjacent disconnected sections of each of one or more first fingers of the first fingers and connected to a respective second busbar of the at least some of the second busbars, or is disposed between two adjacent disconnected sections of each of one or more second fingers of the second fingers and connected to a respective first busbar of the at least some of the first busbars. The insulating members extend along the second direction, and include two insulating members respectively disposed on two opposing sides of the respective conductive block. Each respective insulating member of the two insulating members includes an insulating pad and at least one extension member, and each respective extension member of the at least one extension member extends in the second direction and has an end connected to one respective end of two opposite ends of the insulating pad. The insulating pad at least covers a portion of a respective busbar connected to the respective conductive block, the respective extension member covers at least a portion of a section of a respective finger on one side of the respective busbar and disconnected from an adjacent section of the respective finger on an opposite side of the respective busbar, and along the first direction, a first width of the insulating pad is greater than a second width of the respective extension member.

In some embodiments, a ratio of the first width to the second width is 1:2 to 1:1.

In some embodiments, the insulating pad further covers at least one end of two sections of the respective finger disconnected by the respective busbar.

In some embodiments, along a third direction, a first thickness of the insulating pad is greater than a second thickness of the respective extension member. The third direction is a thickness direction of a body of the cell substrate.

In some embodiments, the back-contact photovolte back-contact photovoltaic module includes at least one bridge finger extending along the first direction. One end of each respective bridge finger of the at least one bridge finger is connected to a respective finger disposed between the respective conductive block and the respective insulating member, and another end of the respective bridge finger is connected to the respective conductive block.

In some embodiments, the insulating members include an insulating member that is adjacent to the respective conductive block and further includes an extended portion protruding toward the respective conductive block. The extended portion covers a portion of a respective finger disposed between the respective conductive block and the respective insulating member.

In some embodiments, the extended portion has a first length along the second direction, the insulating pad of the insulating member has a second length along the second direction, and a ratio of the first length to the second length is 1:5 to 1:2.

In some embodiments, the first length is greater than or equal to 0.20 mm, and the second length is 1 mm to 9 mm.

In some embodiments, the extended portion has a third width along the first direction, and a ratio of the third width to the first width is 1:2 to 1:1.

In some embodiments, wherein the third width is 0.2 mm to 0.3 mm, and the first width is 0.3 mm to 0.5 mm.

In some embodiments, the respective conductive block has opposing upper and lower sides, a respective insulating member closest to at least one of the upper and lower sides of the respective conductive block include the insulating pad and the extended portion, and along the first direction, a spacing between the respective conductive block and the extended portion is greater than or equal to 0.20 mm.

In some embodiments, the back-contact photovoltaic module further includes a plurality of interconnecting members spaced apart along the second direction. Each respective interconnecting member of the plurality of interconnecting members is disposed on the respective busbar, and the respective interconnecting member is connected to at least the respective conductive block. The extended portion further covers a portion of the respective busbar connected to the respective conductive block, and on a reference plane defined by the first direction and the second direction, an orthographic projection of the extended portion is overlapped with an orthographic projection of the respective interconnecting member.

In some embodiments, the respective conductive block has opposing upper and lower sides, and at least two insulating pads are spaced apart and disposed adjacent to one of the upper and lower sides, and along a direction away from the respective conductive block, lengths of the at least two insulating pads along the second direction progressively decrease.

In some embodiments, along a direction away from the respective conductive block, a thickness of at least an insulating pad farthest away from the respective conductive block along a third direction progressively decreases. The third direction is a thickness direction of a body of the cell substrate.

In some embodiments, the back-contact photovoltaic module further includes at least two first insulating blocks spaced apart along the first direction. Each respective first insulating block of the at least two first insulating blocks includes two first insulating sub-blocks spaced apart along the second direction. Each of the two first insulating sub-blocks is disposed on a respective side of two opposing sides of the respective conductive block along the second direction, and covers only at least a portion of a respective one of two sections of the respective finger disconnected by the respective conductive block.

In some embodiments, the back-contact photovoltaic module further includes at least two second insulating blocks spaced apart along the first direction. Each of the second insulating blocks includes two second insulating sub-blocks spaced apart along the second direction. One second insulating sub-block covers only at least a portion of one of two sections of the finger disconnected by the busbar.

In some embodiments, along the second direction, a spacing between the two first insulating sub-blocks is greater than a spacing between the two second insulating sub-blocks.

In some embodiments, the insulating member includes two extension members respectively connected to two opposite ends of the insulating pad along the second direction.

In some embodiments, along a direction away from the respective busbar, a second thickness of the respective extension member along a third direction progressively decreases. The third direction is a thickness direction of a body of the cell substrate.

In some embodiments, at least two insulating pads are spaced apart and disposed adjacent to one of two opposing sides of the respective conductive block along the first direction, and thicknesses of the at least two insulating pads along a third direction progressively decrease. The third direction is a thickness direction of a body of the cell substrate.

### BRIEF DESCRIPTION OF THE DRAWINGS

One or more embodiments are exemplarily described with reference to the corresponding figures in the accompanying drawings, and the exemplary descriptions are not to be construed as limiting the embodiments. Unless otherwise particularly stated, the figures in the accompanying drawings are not drawn to scale. To describe the technical solutions in the embodiments of the present disclosure or in the conventional technologies more clearly, the following briefly introduces the accompanying drawings required for describing the embodiments. Apparently, the accompanying drawings in the following description show merely some embodiments of the present disclosure, and a person of ordinary skill in the art can still derive other accompanying drawings from these accompanying drawings without creative efforts.
FIG. 1 is a first schematic partial top view of a back-contact photovoltaic module according to some embodiments of the present disclosure.
FIG. 2 is a partial cross-sectional view of a back-contact photovoltaic module according to some embodiments of the present disclosure.
FIG. 3 is a second schematic partial top view of a back-contact photovoltaic module according to some embodiments of the present disclosure.
FIG. 4 is a schematic top view of an insulating member in a back-contact photovoltaic module according to some embodiments of the present disclosure.
FIG. 5 is a third schematic partial top view of a back-contact photovoltaic module according to some embodiments of the present disclosure.
FIG. 6 is a fourth schematic partial top view of a back-contact photovoltaic module according to some embodiments of the present disclosure.
FIG. 7 is another schematic cross-sectional view of an insulating member in a back-contact photovoltaic module according to some embodiments of the present disclosure.
FIG. 8 is a fifth schematic partial top view of a back-contact photovoltaic module according to some embodiments of the present disclosure.
FIG. 9 is another schematic partial cross-sectional view of a back-contact photovoltaic module according to some embodiments of the present disclosure.
FIG. 10 is yet another schematic partial cross-sectional view of a back-contact photovoltaic module according to some embodiments of the present disclosure.
FIG. 11 is a sixth schematic partial top view of a back-contact photovoltaic module according to some embodiments of the present disclosure.
FIG. 12 is a schematic cross-sectional view of a first insulating sub-block in a back-contact photovoltaic module according to some embodiments of the present disclosure.
FIG. 13 is a schematic cross-sectional view of a second insulating sub-block in a back-contact photovoltaic module according to some embodiments of the present disclosure.
FIG. 14 is a schematic partial top view of an insulating structure corresponding to a finger in a back-contact photovoltaic module according to some embodiments of the present disclosure.
FIG. 15 is a seventh schematic partial top view of a back-contact photovoltaic module according to some embodiments of the present disclosure.
FIG. 16 is a schematic partial cross-sectional view of a back-contact photovoltaic module according to some embodiments of the present disclosure.
FIG. 17 is an eighth schematic partial top view of a back-contact photovoltaic module according to some embodiments of the present disclosure.
FIG. 18 is a schematic top view of an insulating member in a back-contact photovoltaic module according to some embodiments of the present disclosure.
FIG. 19 is a ninth schematic partial top view of a back-contact photovoltaic module according to some embodiments of the present disclosure.
FIG. 20 is another schematic top view of an insulating member in a back-contact photovoltaic module according to some embodiments of the present disclosure.
FIG. 21 is a tenth schematic partial top view of a back-contact photovoltaic module according to some embodiments of the present disclosure.
FIG. 22 is another schematic partial cross-sectional view of a back-contact photovoltaic module according to some embodiments of the present disclosure.
FIG. 23 is yet another schematic partial cross-sectional view of a back-contact photovoltaic module according to some embodiments of the present disclosure.
FIG. 24 is an eleventh schematic partial top view of a back-contact photovoltaic module according to some embodiments of the present disclosure.
FIG. 25 is a twelfth schematic partial top view of a back-contact photovoltaic module according to some embodiments of the present disclosure.
FIG. 26 is a schematic cross-sectional view of a first insulating block in a back-contact photovoltaic module according to some embodiments of the present disclosure.
FIG. 27 is a schematic cross-sectional view of a second insulating block in a back-contact photovoltaic module according to some embodiments of the present disclosure.
FIG. 28 is a schematic partial top view of an insulating strip corresponding to a finger in a back-contact photovoltaic module according to some embodiments of the present disclosure.

### DETAILED DESCRIPTION

As understood from the background, the structural stability of a back-contact photovoltaic module needs to be enhanced.

Embodiments of the present disclosure provide a back-contact photovoltaic module. The design of the insulating member including the insulating pad not only ensures that the interconnecting member subsequently connected to the conductive block does not come into contact with a disconnected end of a polarity-opposite finger, thereby avoiding a short circuit between the first finger and the second finger, but also ensures that higher support points are provided for the interconnecting member. This design allows the interconnecting member to be supported by both the conductive block and the insulating pad along the second direction, which is conducive to increasing the overall elevated portion of the interconnecting member. On one hand, it is conducive to preventing excessive local bending of the interconnecting members, thereby reducing the risk that the interconnecting member applies a large stress to the adjacent busbar and finger, which could lead to fracture of the adjacent busbar and finger. On the other hand, the insulating pad covering the busbar helps to avoid that the molten material of the interconnecting member drips on the busbar under high-temperature conditions and causes fracture of the busbar, thereby further reducing the risk of fracture of the busbar. Moreover, at least one insulating member, disposed adjacent to the conductive block, is designed to further include an extended portion protruding toward the conductive block. The extended portion covers a portion of the finger disposed between the conductive block and the insulating member, which can effectively prevent fracture of the finger at this position. Therefore, under the multifaceted effects of the insulating members, it is not only conductive to preventing short circuits between the first fingers and the second fingers, as well as reducing the risk of fracture of the fingers or the busbars, but also conductive to reduce the bending degree of the interconnecting members so as to reduce the stress exerted by the interconnecting members on the cell substrate so that the structural stability of the back-contact photovoltaic module is significantly enhanced.

In the description of the embodiments of the present disclosure, the technical terms "first" "second" and the like are only used to distinguish different objects and cannot be understood as indicating or implying relative importance or implicitly indicating the number, specific order, or primary and secondary relationship of the indicated technical features. In the description of the embodiments of the present disclosure, "a plurality of" means at least two, unless otherwise specified.

Reference herein to "embodiment" means that a particular feature, structure, or characteristic described in connection with the embodiment may be included in at least one embodiment of the present disclosure. The appearances of this phrase in various places in the specification are not necessarily all referring to the same embodiment, nor are separate or alternative embodiments that are mutually exclusive with other embodiments. It is explicitly and implicitly understood by those skilled in the art that the embodiments described herein may be combined with other embodiments.

In the description of the embodiments of the present disclosure, the term "and/or" is merely an association relationship describing associated objects, indicating that there may be three relationships, for example, A and/or B, which may indicate that A exists, A and B exist at the same time, and B exists. In addition, the character "/" in this specification generally indicates an "or" relationship between the associated objects.

In the description of the embodiments of the present disclosure, the term "a plurality of" means at least two, similarly, "a plurality of groups" means at least two groups, and "a plurality of pieces" means at least two pieces.

In the description of the embodiments of the present disclosure, orientation or positional relationship indicated by technical terms "center", "transverse", "longitudinal", "length", "width", "thickness", "up", "down", "front", "rear", "left", "right", "vertical", "horizontal", "top", "bottom", "inside" "outside", "clockwise", "counterclockwise", "axial", "radial", "circumferential" and the like are orientations or positional relationships based on those shown in the accompanying drawings, which are intended only to facilitate the description of embodiments of the present disclosure and to simplify the description, and are not intended to indicate or imply that the device or element referred to must have a particular orientation, be constructed and operated with a particular orientation, and therefore are.

In the description of the embodiments of the present disclosure, unless otherwise specified and limited, technical terms "mounted", "connected", "connecting", "fixed", etc. are to be understood in a broad sense. For example, it may be a fixed connection, a removable connection, or a one-piece connection, it may be a mechanical connection, or an electrical connection, it may be a direct connection, or an indirect connection through an intermediate medium, and it may be a connection between two elements or an interaction between the two elements. For those of ordinary skill in the art, specific meanings of the above terms in the embodiments of the present disclosure may be understood according to specific situations.

In the accompanying drawings corresponding to the embodiments of the present disclosure, for better understanding and ease of description, the thickness and area of a layer are enlarged. When a component (e.g., a layer, a film, a region, or a substrate) is described as being formed over another component or over a surface of another component, the component may be "directly" on the surface of another component, or a third component may exist between the two components. In contrast, when a component is described as being formed on a surface of another component or a surface of a component is formed or provided with another component, there is no third component between the two components. In addition, when a component is described as being "substantially" formed on/over another component, it means that the component is not formed on/over the entire surface (or front surface) of another component, nor on/over a portion of the edge of the entire surface.

In the description of the embodiments of the present disclosure, when a component "includes" another component, unless otherwise stated, other components are not excluded, and other components may be further included in the component. In addition, when a component such as a layer, a film, a region, or a plate is referred to as being "over/disposed over" another component, it may be "directly on" another component (i.e., being on the surface of another component and there is no other component therebetween), or another component may exist therebetween. Furthermore, when a component such as a layer, film, region, plate, etc. is "directly on" another component, or when a component such as a layer, film, region, plate, etc. is disposed on the surface of another component, it means that no other component is disposed therebetween.

The terminology used in the description of the various described embodiments herein is for the purpose of describing particular embodiments only and is not intended to be limiting. As used in the description of the various embodiments described and the appended claims, "the portion" is also intended to include the plural forms as well, unless the context clearly indicates otherwise. The component includes a layer, a film, a region, or a plate, etc.

The following describes the embodiments of the present disclosure in detail with reference to the accompanying drawings. However, a person of ordinary skill in the art may understand that in the embodiments of the present disclosure, many technical details are provided to make readers better understand the embodiments of the present disclosure. However, even without these technical details and various changes and modifications based on the following embodiments, the technical solutions claimed in the embodiments of the present disclosure can be implemented.

Some embodiments of the present disclosure provide a solar cell. Hereinafter, the cell solar according to the embodiments of the present disclosure is described in detail with reference to the accompanying drawings.

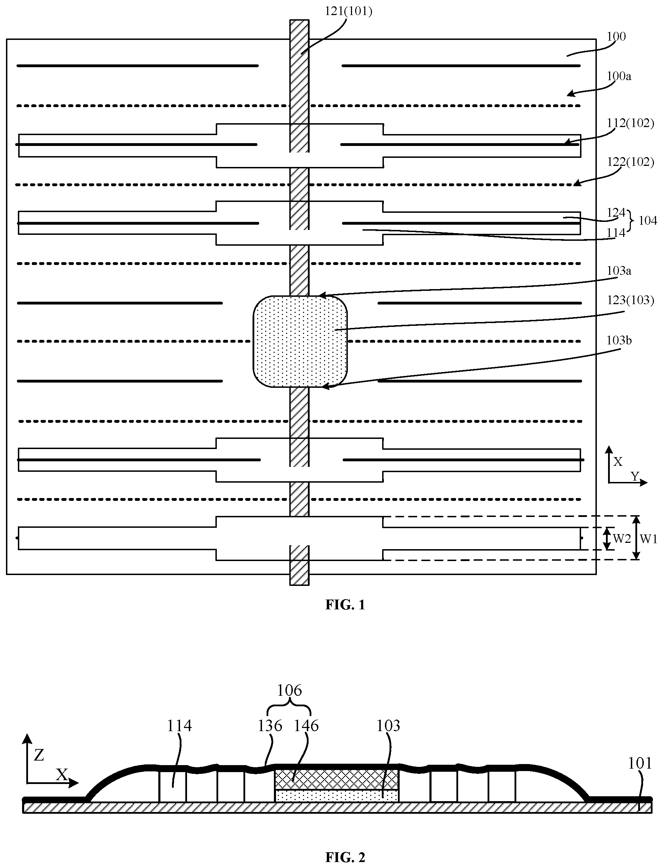

Referring to FIG. 1 to FIG. 4, a back-contact photovoltaic module includes a cell substrate 100, a plurality of busbars 101 and a plurality of fingers 102, a plurality of conductive blocks 103 and insulating members 104. The plurality of busbars 101 and the plurality of fingers 102 are arranged on the cell substrate 100, for example, on a back surface 100a of the cell substrate 100. The plurality of fingers 102 include first fingers 112 and second fingers 122 alternatingly arranged along a first direction X. The plurality of busbars 101 include first busbars 111 and second busbars 121 alternatingly arranged along a second direction Y. Each of the first fingers 112 and second fingers 122 includes a plurality of disconnected sections, each first busbar 111 of at least some of the first busbars 111 is between two adjacent disconnected sections of each of the second fingers 122, and each second busbar 121 of at least some of the second busbars 121 is between two adjacent disconnected sections of each of the first fingers 112. A respective conductive block 103 of the plurality of conductive blocks 103 is disposed between respective two adjacent disconnected sections of each of one or more first fingers 112 of the first fingers 112 and connected to a respective second busbar 121 of the at least some of the second busbars 121, or is disposed between respective two adjacent disconnected sections of each of one or more second fingers 122 of the second fingers 122 and connected to a respective first busbar 111 of the at least some of the first busbars 111. The insulating members 104 extend along the second direction, and include two insulating members 104 respectively disposed on two opposing sides of the respective conductive block 103. Each respective insulating member 104 of the two insulating members 104 includes an insulating pad 114 and at least one extension member 124, and each respective extension member 124 of the at least one extension member 124 extends in the second direction and has an end connected to one respective end of two opposite ends of the insulating pad 114. The insulating pad 114 at least covers a portion of a respective busbar connected to the respective conductive block 103, the respective extension member 124 covers at least a portion of a section of a respective finger on one side of the respective busbar and disconnected from an adjacent section of the respective finger on an opposite side of the respective busbar, and along the first direction, a first width of the insulating pad 114 is greater than a second width of the respective extension member 124.

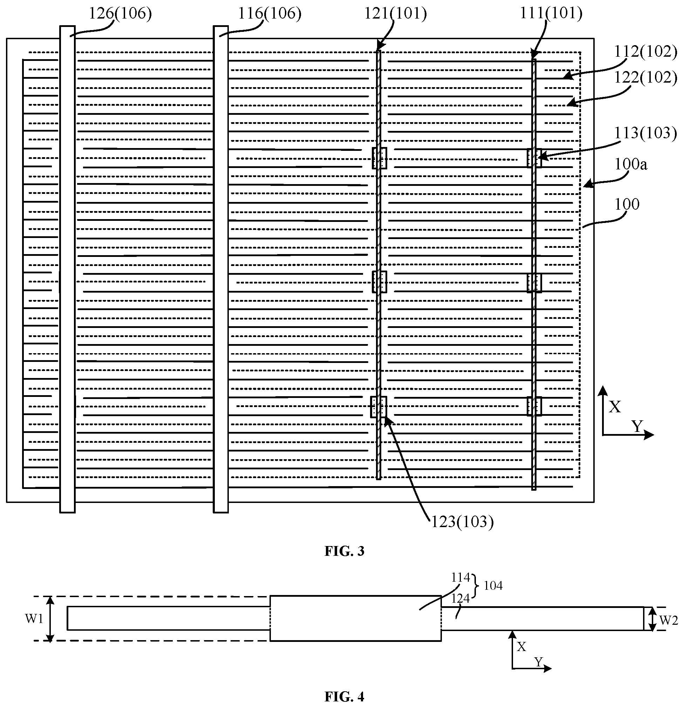

It should be noted that FIG. 1 is a first partial top view of a back-contact photovoltaic module according to some embodiments of the present disclosure, FIG. 2 is a partial cross-sectional view of a back-contact photovoltaic module according to some embodiments of the present disclosure, FIG. 3 is a second schematic partial top view of a back-contact photovoltaic module according to some embodiments of the present disclosure, and FIG. 4 is a schematic top view of an insulating member in a back-contact photovoltaic module according to some embodiments of the present disclosure. For differentiation between the first finger 112 and the second finger 122, FIG. 1 and FIG. 2 illustrate the first finger 112 with a thicker solid line and the second finger 122 with a thicker dashed line. In FIG. 1, the insulating member 104 is depicted in a perspective view. In addition, similar to the case where the "finger 102" refers to either the first finger 112 or the second finger 122, and "busbar 101" refers to either the first busbar 111 or the second busbar 121, the conductive block 103 described in the subsequent paragraphs may refer to either a first conductive block 113 or a second conductive block 123. Similarly, the interconnecting member 106 may refer to either a first interconnecting member 116 or a second interconnecting member 126.

Furthermore, for clearer illustration of positional relationships between the busbar 101, the finger 102, and the conductive block 103, FIG. 3 illustrates only two interconnecting members 106, with the interconnecting members 106 depicted in a perspective view. In FIG. 4, the insulating pad 114 and the extension member 124 included in the insulating member 104 are delineated by dashed lines.

It should be noted, in the back-contact photovoltaic module according to some embodiments of the present disclosure, special design considerations are made for the insulating member with respect to the surrounding area of the conductive block 103. Specifically, at least two insulating members 104 are designed to be disposed on two opposing sides of the same conductive block 103 along the first direction X. That is, at least one insulating member 104 is arranged on each of the two opposing sides of the conductive block 103 along the first direction X. In other words, at least two insulating members 104 disposed on the two opposing sides of the same conductive block 103 along the first direction X may be considered as one insulating group, and one insulating group is correspondingly provided around one conductive block 103.

Moreover, each of the insulating members 104 includes an insulating pad 114 and at least one extension member 124. The insulating pad 114 at least covers a portion of the busbar 101 connected to the conductive block 103. In this way, the insulating pad 114 not only protects a portion of the busbar 101 to reduce the risk of fracture of the busbar 101, but also provides a higher support point for the interconnecting member 106.

In some cases, with reference to FIG. 2 and FIG. 3, the interconnecting member 106 includes a welding strip 136 and a solder paste 146. When connecting, for example, welding the interconnecting member 106 to the conductive block 103, the solder paste 146 in the interconnecting member 106 allows electrical connection of the welding strip 136 to the conductive block 103. However, along a third direction Z, the conductive block 103 is disposed on the busbar 101, and due to the solder paste 146 in the interconnecting member 106, a height difference is present between the interconnecting member 106 and the busbar 101. The insulating pad 114 is also designed to be disposed on the busbar 101 so that a larger area of the subsequently formed interconnecting member 106 is supported by higher support points along the first direction X. In other words, not only a portion of the welding strip 136 in contact with the conductive block 103 in the interconnecting member 106 is elevated, and but also a portion of the welding strip 136 in contact with the insulating pad 114 is elevated, so that an elevated portion of the welding strip 136 as a whole is increased. In this way, on one hand, this helps to avoid excessive local bending of the welding strip 136, that is, from the perspective of the entire interconnecting member 106, the bending degree of the welding strip 136 per unit length is reduced, instead of the case where only the portion of the welding strip 136 connected to the conductive block 103 is elevated. In other words, this helps to slow a bending tendency of the welding strip 136. On the other hand, avoiding excessive local bending of the welding strip 136 is conducive to reducing the risk of the interconnecting member 106 applying large stress to the busbar 101 and finger 102 adjacent thereto and making them susceptible to fracture. In addition, the insulating pad 114 covering the busbar 101 helps to avoid that the molten material of the interconnecting member 106 drips on the busbar 101 under high-temperature conditions and causes the busbar 101 to fracture, thereby further reducing the risk of fracture of the busbar 101. The third direction Z is a thickness direction of the cell substrate 100. It is worth emphasizing that the bending degree of the interconnecting member 106 described in the subsequent paragraphs primarily refers to the bending degree of the welding strip 136 in the interconnecting member 106.

Moreover, with reference to FIG. 1 and FIG. 4, each of the insulating members 104 includes an insulating pad 114 and at least one extension member 124. The extension member 124 covers a portion of a finger 102 that is disconnected by the busbar 101. This design ensures that the interconnecting member 106 subsequently connected to the conductive block 103 does not come into contact with a disconnected end of a polarity-opposite finger, so that short circuits between the first fingers 112 and the second fingers 122 are prevented. Furthermore, the second width W2 of the extension member 124 is designed to be less than the first width W1 of the insulating pad 114, which facilitates reducing the amount of an insulating material required for forming the extension member 124 to reduce the amount of an insulating material required for forming the insulating member 104, while enhancing an insulating effect of the insulating member 104 on the covered finger 102 by virtue of the extension member 124. In this way, the preparation cost of the insulating member 104 is reduced, and warping of the back-contact photovoltaic module caused by volume shrinkage of the insulating material covering a large area is prevented.

In summary, under the multifaceted effects of the insulating members 104, it is not only conductive to preventing short circuits between the first fingers 112 and the second fingers 122, as well as reducing the risk of fracture of the fingers 102 or the busbars 101, but also conductive to reduce the bending degree of the interconnecting members 106 so as to reduce the stress exerted by the interconnecting members 106 on the cell substrate 100 so that the structural stability of the back-contact photovoltaic module is significantly enhanced.

It is worth emphasizing that each of the insulating members 104 covers only one finger 102, which is disconnected by the busbar 101, and that the insulating members 104 are designed only on some of the fingers 102 adjacent to the conductive block 103 along the first direction X. In this way, compared with laying the insulating material in a large area around the conductive block, this design is conducive to ensuring that the insulating member 104 covers the areas of the busbar 101 and the finger 102 that are more susceptible to fracture, so that the risk of fracture of the busbar 101 and the finger 102 is reduced. In addition, this design helps to reduce the bending degree of the interconnecting member 106 that is subsequently electrically connected to the conductive block 103, while reducing a total layout area occupied by the insulating member 104 on the cell substrate 100 to reduce the amount of the insulating material required for forming the insulating member 104. In this way, the preparation cost of the insulating member 104 is reduced, and warping of the back-contact photovoltaic module caused by volume shrinkage of the insulating material covering a large area is prevented.

It should be noted, based on different polarities, the fingers 102 may be categorized into first fingers 112 and second fingers 122. Likewise, the busbars 101 may be categorized into first busbars 111 and second busbars 121. The first busbars 111 are configured to collect currents on all the first fingers 112, and the second busbars 121 are configured to collect currents on all the second fingers 122. In this case, the plurality of conductive blocks 103 may be categorized into first conductive blocks 113 and second conductive blocks 123. The first conductive blocks 113 are disposed at disconnected positions of the second fingers 122 and connected to the first busbars 111, and the second conductive blocks 123 are disposed at disconnected positions of the first fingers 112 and connected to the second fingers 121. The disconnected positions of the second fingers 122 are configured to allow the respective first busbar 111 to extend along the first direction X and to be electrically connected to the first fingers 112. The disconnected positions of the first fingers 112 are configured to allow the respective second busbar 121 to extend along the first direction X and to be electrically connected to the second fingers 122.

Furthermore, based on the types of the connected conductive blocks 103, the interconnecting members 106 may be categorized into first interconnecting members 116 and second interconnecting members 126. The first interconnecting members 116 come into contact with the first conductive blocks 113 to collect currents on the first busbars 111, and the second interconnecting members 126 come into contact with the second conductive blocks 123 to collect currents on the second busbars 121.

The embodiments of the present disclosure are described in detail hereinafter with reference to the accompanying drawings.

In some embodiments, referring to FIG. 1, the insulating pad 114 also covers at least one end of two sections of a finger 102 disconnected by the busbar 101. It should be noted that in FIG. 1, as an example, a single insulating pad 114 covers both ends of two sections of the finger 102 disconnected by the busbar 101. In practice, a single insulating pad may cover only one end of two sections of one finger disconnected by the busbar, and the other end of the two sections is covered by the extension member. Alternatively, a single insulating pad may cover only a portion of the busbar, and two ends of two sections of one finger disconnected by the busbar are covered by two extension members.

It should be noted that, no matter whether the two ends of the two sections of the finger disconnected by the busbar are covered by the insulating pad 114 or the extension members 124, it can be ensured that the interconnecting member 106 connected to the conductive block 103 does not come into contact with an end of a polarity-opposite finger at the disconnected position.

In some embodiments, referring to FIG. 1, the insulating member 104 includes two extension members 124. The two extension members 124 are respectively connected to two opposite ends of the insulating pad 114 along the second direction Y In this way, it is conducive to improving the integrity and symmetry of the insulating effect of the insulating member 104 on the finger 102 covered by the insulating member 104. In other cases, any insulating member may include one insulating pad and one extension member. The extension member is connected to one of two opposite ends of the insulating pad along the second direction. The insulating member covers both ends of two sections of a finger disconnected by the busbar.

In some embodiments, referring to FIG. 1 and FIG. 2, along the third direction Z, a first thickness of the insulating pad 114 is greater than a second thickness of the extension member 124. The third direction Z refers to a thickness direction of the cell substrate 100. It should be noted the interconnecting member 106, which is electrically connected to the conductive block 103, is primarily disposed on the insulating pad 114. The insulating pad 114 elevates the welding strip 136 in the interconnecting member 106. For example, a height of the welding strip 136 after being elevated by the insulating pad 114 is the same as a height of the welding strip 136 after being collaboratively elevated by the conductive block 103 and the solder paste 146. The extension members 124, disposed on the two opposing sides of the insulating pad 114 along the second direction Y, only need to cover the finger 102 to achieve an excellent protection effect on the finger 102. Based on this, designing the first thickness of the insulating pad 114 to be greater than the second thickness of the extension member 124 helps to increase an overall height of the welding strip 136 by virtue of the insulating pad 114, while reducing the second thickness of the extension member 124, which further reduces the amount of the insulating material required for forming the extension member 124 and in turn reduces the amount of the insulating material required for forming the insulating member 104. In this way, the preparation cost of the insulating member 104 is reduced, and warping of the back-contact photovoltaic module caused by volume shrinkage of the insulating material covering a large area is prevented.

In some embodiments, referring to FIG. 1, along a direction away from the busbar 101, the second thickness of the extension member 124 progressively decreases. It should be noted along the second direction Y, the portion of the finger 102 that is farther from the busbar 101 is less likely to come into contact with the interconnecting member 106, thereby reducing the occurrence of short circuits caused by the interconnecting member 106 connecting fingers of different polarities. Accordingly, designing the second thickness of the extension member 124 to progressively decrease along the direction away from the busbar 101 is conducive to reducing the amount of the insulating material required for forming the extension member 124 and in turn reducing the amount of the insulating material required for forming the insulating member 104 while ensuring that the extension member 124 provides good protection for the finger 102 to effectively prevent a short circuit between the first finger 112 and the second finger 122. In this way, the preparation cost of the insulating member 104 is reduced, and warping of the back-contact photovoltaic module caused by volume shrinkage of the insulating material covering a large area is prevented.

It should be noted that for the same extension member 124, as the second thickness of the extension member 124 progressively decreases along the direction away from the busbar 101, the second thickness of the extension member 124 along the third direction Z may be considered as the thickness of a thickest part of the extension member 124 along the third direction Z, i.e., the second thickness of the extension member 124 may be regarded as the maximum thickness of the extension member 124 along the third direction Z. The second thickness of the extension member 124 may also be less than the first thickness of the insulating pad 114. In practice, along the third direction, the thicknesses of various regions of the extension member may also be uniform, and the second thickness of the extension member may be considered as the thickness of any region of the extension member, and the second thickness of the extension member may also be less than the first thickness of the insulating pad.

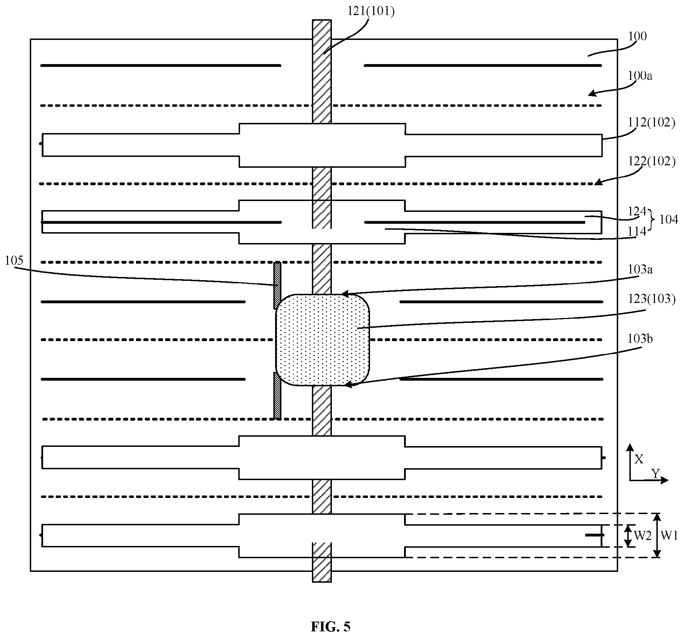

In some embodiments, referring to FIG. 5, FIG. 5 is a third schematic partial top view diagram of a back-contact photovoltaic module according to some embodiments of the present disclosure. The back-contact photovoltaic module may further include at least one bridge finger 105 extending along the first direction X. One end of the bridge finger 105 is connected to a finger 102 disposed between the conductive block 103 and the insulating member 104, and the other end of the bridge finger 105 is connected to the conductive block 103.

It should be noted that a finger 102, disposed between the conductive block 103 and the insulating member 104 closest to the conductive block 103, is most affected by the solder paste 146 in the interconnecting member 106. In general, this finger 102 may come into contact with the busbar 101 electrically connected to the conductive block 103. However, due to the influence of the solder paste 146 (referring to FIG. 2) in the interconnecting member 106 (referring to FIG. 2) or the stress applied to the cell substrate 100 by the interconnecting member 106, a portion of the finger 102 adjacent to the insulating member 104 and not covered by the insulating member 104 may also be susceptible to fracture. Therefore, the bridge finger 105 is designed to directly electrically connect the finger 102, which is most prone to finger fracture, to the conductive block 103. In this way, even if the portion of the finger 102 become inoperative for current transmission to the busbar 101 due to fracture, the current can still be transmitted through the bridge finger 105 to the conductive block 103. In other words, the design of the bridge finger 105 facilitates further ensuring that the interconnecting member 106 collects currents on all fingers 102 of the same polarity, e.g., all first fingers 112 or all second fingers 122, to improve the photovoltaic conversion efficiency of the back-contact photovoltaic module.

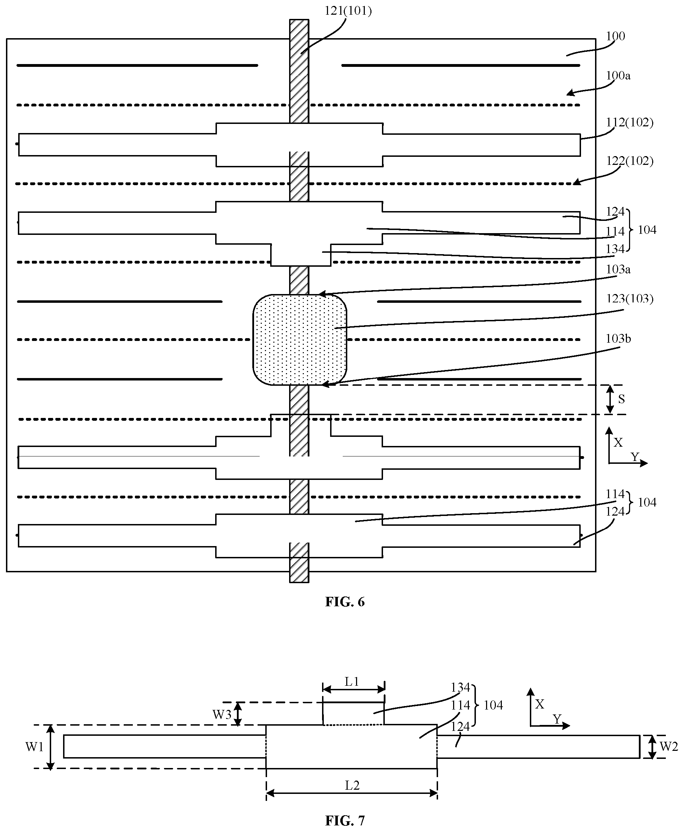

In some embodiments, referring to FIG. 6, which is a fourth schematic partial top view of a back-contact photovoltaic module according to some embodiments of the present disclosure, at least one insulating member 104, disposed adjacent to the conductive block 103, further includes an extended portion 134 protruding toward the conductive block 103. The extended portion 134 covers a portion of the finger 102 disposed between the conductive block 103 and the insulating member 104. In other words, the extended portion 134 covers a portion of the finger 102 that is disposed adjacent to and electrically connected to the conductive block 103. Since the finger 102 is closest to the conductive block 103, when the interconnecting member 106 is connected, for example, welded to the conductive block 103, a portion of the interconnecting member 106 directly above the finger 102 is more affected by the temperature. Designing the extended portion 134 to cover the finger 102 effectively prevents fracture of the finger 102 at this position.

It should be emphasized that each of the insulating members 104 includes an insulating pad 114 and at least one extension portion 124, and only some of insulating members 104 further include the extended portion 134. For example, only the insulating member 104 closest to the conductive block 103 along the first direction X include the extended portion 134. In a single group of insulating members, only two insulating members 104 each include the extended portion 134, and are disposed on opposing sides of the conductive block 103 along the first direction X respectively. In this way, the risk of fracture of the finger 102 closest to the conductive block 103 can be effectively reduced, and the total layout area of the insulating member 104 on the battery substrate 100 is minimized.

In some cases, referring to FIG. 7, which is another cross-sectional diagram of an insulating member in a back-contact photovoltaic module according to some embodiments of the present disclosure, along the second direction Y, the extended portion 134 has a first length L1, and the insulating pad 114 has a second length L2. A ratio of the first length L1 to the second length L2 ranges from 1:2 to 1:5. For example, the ratio of the first length L1 to the second length L2 may be 1:4, 3:10, 1:3, or 2:5.

Referring to FIG. 6 and FIG. 7, in a case where the ratio of the first length L1 to the second length L2 is less than 1:5, the finger 102 adjacent to the conductive block 103 has a relatively small area covered by the extended portion 134, which is not conducive to improving the protective effect of the extended portion 134 on the finger 102. In a case where the ratio of the first length L1 to the second length L2 is greater than 1:2, the total layout area of the extended portion 134 on the cell substrate 100 becomes relatively large, which affects the total layout area of the insulating member 104 on the cell substrate 100, and thus is not conducive to both reducing the volume of the insulating member 104 and preventing warping of the back-contact photovoltaic module. Thus, designing the ratio of the first length L1 to the second length L2 to be between 1:5 and 1:2 is conducive to ensuring that the extended portion 134 provides good protection for the finger 102, so that the risk of fracture of the finger 102 is effectively reduced while the volume of the insulating member 104 is reduced to prevent severe warping of the back-contact photovoltaic module.

It should be noted that in FIG. 7, the insulating pad 114, the extension member 124, and the extended portion 134 included in the insulating member 104 are delineated by dashed lines.

In some examples, along the second direction Y, the first length L1 of the extended portion 134 may be greater than or equal to 0.20 mm. For example, the first length L1 may be 0.25 mm, 0.3 mm, 0.35 mm, 0.4 mm, 0.42 mm, 0.45 mm, or 0.5 mm, to ensure that the extended portion 134 provides good protection for the finger 102.

In some examples, along the second direction Y, the second length L2 of the insulating pad 114 may range from 1 mm to 9 mm. For example, the second length L2 may be 1.5 mm, 1.8 mm, 2 mm, 2.5 mm, 3 mm, 3.5 mm, 4 mm, 4.5 mm, 5 mm, 5.5 mm, 6 mm, 6.5 mm, 7 mm, 7.5 mm, 8 mm, or 8.5 mm.

With reference to FIG. 6 and FIG. 7, in a case where the second length L2 is less than 1 mm, the insulating pad 114 is shorter, and can only provide limited support strength for the interconnecting member 106 (referring to FIG. 3). When the interconnecting member 106 is placed on the conductive block 103 and connected, for example, welded to the conductive block 103, due to a small support area of the insulating pad 114 for the interconnecting member 106, the interconnecting member 106 is susceptible to instability, such as tilting, leading to relative displacement between the interconnecting member 106 and the conductive block 103. Moreover, the shorter insulating pad 114 provides a smaller stress buffer effect, leading to larger local stress exerted on the cell substrate 100 during welding. In a case where the second length L2 is greater than 9 mm, the insulating pad 114 is longer, leading to a larger overall layout area of the insulating pad 114 on the cell substrate 100. This may affect the total layout area of the insulating member 104 on the cell substrate 100, which is not conducive to both reducing the volume of the insulating member 104 and preventing warping of the back-contact photovoltaic module. Thus, designing the second length L2 to range from 1 mm to 9 mm is conducive to ensuring that the insulating pad 114 provides a sufficient support strength for the interconnecting member 106 and offers a good stress buffering effect, so as to effectively prevent relative displacement of the interconnecting member 106 and the conductive block 103, and stress concentration, while reducing the volume of the insulating member 104 to prevent significant warping of the back-contact photovoltaic module.

It should be noted that along the second direction Y, in different insulating members 104, the ratios of the length of the extended portion 134 to the length of the insulating pad 114 may be the same or different. In different insulating members 104, the lengths of different extended portions 134 may be the same or different. In different insulating members 104, the lengths of different insulating pads 114 may be the same or different.

In some cases, with continued reference to FIG. 7, along the first direction X, the extended portion 134 has a third width W3. A ratio of the third width W3 to the first width W1 ranges from 1:2 to 1:1. For example, the ratio of the third width W3 to the first width W1 may be 3:5, 7:10, 4:5, or 9:10. The first width W1 is the width of the insulating pad 114.

It should be noted, with reference to FIG. 6 and FIG. 7, in the same insulating member 104, the ratio of the third width W3 to the first width W1 represents the protrusion magnitude of the extended portion 134 relative to the insulating pad 114. In a case where the ratio of the third width W3 to the first width W1 is less than 1:2, the protrusion magnitude of the extended portion 134 protrudes relative to the insulating pad 114 is smaller, resulting a smaller width of the portion of the extended portion 134 between the conductive block 103 and the finger 102 closest to the conductive block 103. In addition, this portion of the extended portion 134 is disposed at the edge of the insulating member 104, where edge thinning susceptibility arises from adhesive overflow, which affects the thickness of the extended portion 134 around the finger 102 and thus weakens the protective effect of the extended portion 134 on the finger 102. In a case where the ratio of the third width W3 to the first width W1 is greater than 1:1, the protrusion magnitude of the extended portion 134 relative to the insulating pad 114 is greater. In this case, the gap between the extended portion 134 and the conductive block 103 becomes smaller, and the insulating material forming the extended portion 134, such as insulating adhesive, is more prone to overflow onto the conductive block 103. When welding the interconnecting member 106 (referencing FIG. 3) onto the conductive block 103, the raw material of the interconnecting member 106, such as a solder paste, may be divided into two parts due to overflow of the insulating adhesive on the conductive block 103 resulting in poor contact between the interconnecting member 106 and the conductive block 103.

Thus, designing the ratio of the third width W3 to the first width W1 to be between 1:2 and 1:1 is conducive to ensuring that the thickness of the extended portion 134 around the finger 102 is not too small, so that it can be ensured that the extended portion 134 achieves a good protective effect on the finger 102, and an appropriate gap is present between the extended portion 134 and the conductive block 103. This effectively prevents the insulating material forming the extended portion 134 from overflowing onto the conductive block 103, and hence prevents a poor contact between the interconnecting member 106 and the conductive block 103.

In some examples, along the first direction X, the third width W3 of the extended portion 134 may range from 0.2 mm to 0.3 mm, for example, 0.22 mm, 0.24 mm, 0.25 mm, 0.26 mm, or 0.28 mm. The first width W1 of the insulating pad 114 may range from 0.3 mm to 0.5 mm, for example, 0.32 mm, 0.34 mm, 0.35 mm, 0.36 mm, 0.38 mm, 0.4 mm, 0.42 mm, 0.44 mm, 0.45 mm, 0.46 mm, or 0.48 mm.

It should be noted that along the first direction X, in different insulating members 104, the ratios of the width of the extended portion 134 to the width of the insulating pad 114 may be the same or different. In different insulating members 104, the widths of different extended portions 134 may be the same or different. In different insulating members 104, the widths of different insulating pads 114 may be the same or different.

In some cases, reference may be made to FIG. 6. The conductive block 103 has two opposing sides along the first direction X, i.e., an upper side 103a and a lower side 103b. One insulating member 104, which is closest to the upper side 103a or the lower side 103b, includes an insulating pad 114 and an extended portion 134. Along the first direction X, a spacing S between the conductive block 103 and the extended portion 134 is greater than or equal to 0.20 mm.

It should be noted that, in FIG. 6, it is shown as an example that the insulating member 104 closest to the upper side 103a includes the insulating pad 114 and the extended portion 134, and the insulating member 104 closest to the lower side 103b includes the insulating pad 114 and the extended portion 134. In practice, it is also possible that only one insulating member closest to the upper side includes the insulating pad and the extended portion, whereas the other insulating members do not include the extended portion. Alternatively, only one insulating member closest to the lower side includes the insulating pad and the extended portion, whereas the other insulating members do not include the extended portion. Moreover, each of the insulating members may include at least one extended portion 124.

It is worth emphasizing that along the first direction X, the spacing S between the conductive block 103 and the extended portion 134 is greater than or equal to 0.20 mm. For example, the spacing S may be 0.25 mm, 0.3 mm, 0.35 mm, 0.4 mm, 0.42 mm, 0.45 mm, or 0.5 mm, etc. This helps to effectively prevent the insulating material constituting the extended portion 134 from overflowing onto the conductive block 103, thereby avoiding poor contact between the interconnecting member 106 and the conductive block 103, and enhancing the structural stability of the back-contact photovoltaic module.

In some embodiments, with reference to FIG. 6 and FIG. 3, the back-contact photovoltaic module may further include: a plurality of interconnecting members 106 spaced apart along the second direction Y. Each interconnecting member 106 is disposed on one respective busbar 101, and the interconnecting member 106 is at least connected to the conductive block 103. The extended portion 134 covers a portion of the busbar 101 connected to the conductive block 103, and with the plane formed by the first direction X and the second direction Y as a reference plane, for the extended portion 134 and the interconnecting member 106 corresponding to the same busbar 101, an orthogonal projection of the extended portion 134 on the reference plane is overlapped with an orthogonal projection of the interconnecting member 106 on the reference plane.

It should be noted when the interconnecting member 106 is bonded (e.g., welded) to the conductive block 103, both the finger 102 and the busbar 101 that are adjacent to the conductive block 103 are susceptible to being affected by the molten material of the interconnecting member 106 under high-temperature conditions. Therefore, the extended portion 134 is designed to not only cover a portion of the finger 102 closest to the conductive block 103 and electrically connected to the conductive block 103, but also cover a portion of the busbar 101 connected to the conductive block 103. This is conducive to using the extended portion 134 to simultaneously protect portions of both the busbar 101 and the finger 102 that are susceptible to fracture, and thus the structural stability of the back-contact photovoltaic module is further improved.

In general, the finger 102 and the busbar 101 disposed directly beneath the interconnecting member 106 are most susceptible to being affected by the molten raw material of the interconnecting member 106 under high-temperature conditions. Therefore, by designing the extended portion 134 and the interconnecting member 106 corresponding to the same busbar 101 such that the orthogonal projection of the extended portion 134 on the reference plane is overlapped with the orthogonal projection of the interconnecting member 106 on the reference plane, it is conducive to ensuring that at least a part of the area directly beneath the interconnecting member 106 is covered by the extended portion 134. This ensures that the extended portion 134 precisely protects the finger 102 and the busbar 101.

It should be noted that the orthogonal projection of the extended portion 134 on the reference plane being overlapped with the orthogonal projection of the interconnecting member 106 on the reference plane includes at least the following cases. In some cases, the orthogonal projection of the extended portion 134 on the reference plane is within the orthogonal projection of the interconnecting member 106 on the reference plane. In other cases, the orthogonal projection of the interconnecting member 106 on the reference plane is within the orthogonal projection of the extended portion 134 on the reference plane. In yet other cases, the orthogonal projections of the extended portion 134 on the reference plane is only partially overlapped with the interconnecting member 106 on the reference plane.

In some embodiments, referring to FIG. 1, FIG. 5, or FIG. 6, two opposing sides of the conductive block 103 along the first direction X are an upper side 103a and a lower side 103b respectively, and the number of insulating pads 114 spaced apart and adjacent to one of the upper side 103a and the lower side 103b ranges from 1 to 6. In other words, at least two insulating pads 114 spaced apart and adjacent to one of two opposing sides of the conductive block 103 along the first direction X are considered as one insulating pad group. The number of insulating pads 114 included in a single insulating pad group, i.e., the number of insulating members 104, ranges from 1 to 6. Thus, the number of insulating pads 114, i.e., the number of insulating members 104, in a single insulating group may range from 2 to 12.

It should be noted during the process of welding the interconnecting member 106 to the conductive block 103, the portion of the interconnecting member 106 adjacent to the conductive block 103 is more affected by temperature. By disposing the insulating pad 114 over the busbar 101 aligned along the third direction Z with the portion of the interconnecting member 106 most affected by temperature and the polarity-opposite finger 102 electrically insulated from the busbar 101, the risk of fracture of the finger 102 and the busbar 101 can be significantly reduced, and the bending degree of the welding strip 136 caused by a height difference between the conductive block 103 and the busbar 101 can be significantly reduced. In this way, there is no need to design the insulating member 104 including the insulating pad 114 in a region away from the conductive block 103. In other words, by designing the number of insulating pads 114 spaced apart and adjacent to at least one of the upper side 103a and the lower side 103b to range from 1 to 6, the risk of fracture of the finger 102 and the busbar 101 can be significantly reduced, and the bending degree of the welding strip 136 can be notably mitigated. In addition, this approach prevents an excessive number of insulating pads 114 which results in an increase in the total layout area of the insulating member 104 on the cell substrate 100.

It should be noted that in FIG. 1, FIG. 5, and FIG. 6, the number of insulating pads 114 in a single insulating pad group is shown as 2, for example. In practices, the number of insulating pads in a single insulating pad group may also be 1, 3, 4, 5, or other values.

In some cases, the number of insulating pads 114 spaced apart and adjacent to the upper side 103a may be equal to the number of insulating pads 114 spaced apart and adjacent to the lower side 103b, which is conducive to causing the region of the interconnecting member 106 adjacent to the upper side 103a and away from the lower side 103b to be elevated by the insulating pad 114 to a height that is nearly identical to a height to which the region of the interconnecting member 106 adjacent to the lower side 103b and away from the upper side 103a is elevated by the insulating pad 114. This is more conducive to assisting the gradual change in the bending degree of the interconnecting member 106. In one example, the conductive block 103 may have a centerline extending along the second direction Y, and one insulating pad group adjacent to the upper side 103a and away from the lower side 103b may be axially symmetric with one insulating pad group adjacent to the lower side 103b and away from the upper side 103a about the centerline.

It should be noted that, in practice, the number of insulating pads 114 spaced apart and adjacent to the upper side 103a may be different from the number of insulating pads 114 spaced apart and adjacent to the lower side 103b, and adjustments may be made according to actual needs.

The following provides detailed description of the design of lengths of a plurality of insulating pads 114 along the second direction Y within a single insulating pad group.

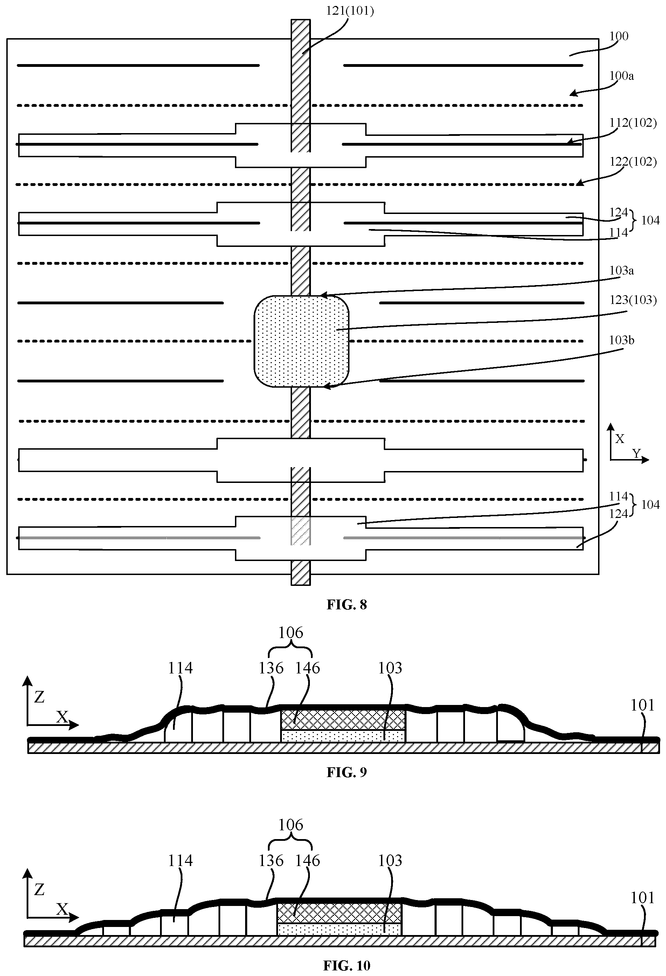

In some embodiments, referring to FIG. 8, FIG. 8 is a fifth schematic partial top view of a back-contact photovoltaic module according to some embodiments of the present disclosure. The conductive block 103 has an upper side 103a and a lower side 103b along the first direction X. At least two insulating pads 114 are spaced apart and adjacent to one of the upper side 103a and the lower side 103b, and along the direction (i.e., the first direction X) away from the conductive block 103, lengths of the at least two insulating pads 114 in the second direction Y progressively decrease. In other words, the at least two insulating pads 114, which are spaced apart and adjacent to one of the two opposing sides of the conductive block 103 along the first direction X, are considered as one insulating pad group. Along the direction away from the conductive block 103, the lengths of the at least two insulating pads 114 in the second direction Y within a single insulating pad group progressively decrease. That is, the farther an insulating pad 114 is from the conductive block 103, the shorter the insulating pad 114 is along the second direction Y.

Thus, based on variations in distance between the insulating pad and the conductive block 103, that is, variations in temperature during the process of welding the interconnecting member 106 to the conductive block 103 (referring to FIG. 3), the design of the insulating pad 114 farther away from the conductive block 103 having a smaller length in the second direction Y facilitates reducing the amount of the insulating material required for forming the insulating pad 114, which is conducive to lowering the preparation cost of the insulating member 104 and avoiding warping of the back-contact photovoltaic module caused by volume shrinkage of the insulating material covering a large area. In addition, such design also facilitates elevating more regions of the interconnecting member 106 with the plurality of insulating pads 114 disposed on the upper side 103a and the lower side 103b of the conductive block 103, so that bending of the interconnecting member 106 is mitigated, and the interconnecting member 106 is prevented from applying excessive stress to the cell substrate 100.

In some cases, at least two insulating pads 114 spaced apart and adjacent to one of the upper side 103a and the lower side 103b are considered as an insulating pad group. In a single insulating pad group, lengths of at least two insulating pads 114 in the second direction Y progressively decrease from 9 mm to 1 mm along a direction away from the conductive block 103.

For each of the insulating pads 114, in a case where the second length of the insulating pad 114 along the second direction Y is less than 1 mm, the insulating pad 114 is relatively short, and the support strength of such insulating pad 114 for the interconnecting member 106 may be limited. When the interconnecting member 106 is placed on the conductive block 103 and connected, for example, welded to the conductive block 103, due to a small support area of the insulating pad 114 for the interconnecting member 106, the interconnecting member 106 is susceptible to instability, leading to relative displacement between the interconnecting member 106 and the conductive block 103. Moreover, the shorter insulating pad 114 provides a smaller stress buffer effect, which is prone to a large local stress exerted on the cell substrate 100 during welding. In a case where the second length of the insulating pad 114 along the second direction Y is greater than 9 mm, the insulating pad 114 is relatively long, and the overall layout area of the insulating pad 114 on the cell substrate 100 is increased. This may affect the total layout area of the insulating member 104 on the cell substrate 100, which is not conducive to both reducing the volume of the insulating member 104 and preventing warping of the back-contact photovoltaic module.

In this way, in the direction away from the conductive block 103, the lengths of at least two insulating pads 114 along the second direction Y may progressively decrease from 9 mm to 1 mm. This design ensures that the insulating pads 114 adjacent to the conductive block 103 provide sufficient supporting strength for the interconnecting member 106 to achieve an excellent effect of stress buffering. As a result, relative displacement and stress concentration between the interconnecting member 106 and the conductive block 103 are effectively prevented. In addition, the insulating pads 114 farther from the conductive block 103 in the second direction Y is shorter, which effectively reduces the layout area of the entire insulating pad group on the cell substrate 100. This helps to prevent severe warping of the back-contact photovoltaic module, and reduce the preparation cost required for each insulating pad group.

The following provides detailed description of the design of thicknesses of a plurality of insulating pads 114 along the third direction Z in a single insulating pad group. The third direction Z is the thickness direction of the cell substrate 100.

In some embodiments, referring to FIG. 9, which is another schematic partial cross-sectional view of a back-contact photovoltaic module according to some embodiments of the present disclosure, along the direction away from the conductive block 103, the thickness of at least the insulating pad 114 farthest away from the conductive block 103 progressively decreases along the third direction Z.

In some other embodiments, referring to FIG. 10, which is yet another schematic partial cross-sectional view of a back-contact photovoltaic module according to some embodiments of the present disclosure, at least two insulating pads 114 spaced apart and adjacent to one of two opposing sides of the conductive block 103 along the first direction X is regarded as one insulating pad group, and in a single insulating pad group, along the direction away from the conductive block 103, the thicknesses of the at least two insulating pads 114 along the third direction Z progressively decrease.

In the above embodiments as illustrated in FIG. 9 or FIG. 10, in the direction away from the conductive block 103, heights of the support points provided by the plurality of insulating pads 114 in a single insulating pad group progressively decrease. This design helps to assist in gradual bending of the interconnecting member 106, and thus effectively prevents excessive bending in local areas of the interconnecting member 106. Therefore, it is conducive to reducing overall bending of the interconnecting member 106 along the third direction Z, thereby further reducing the risk of fracture of the adjacent busbar 101 and finger 102 due to significant stress applied by the interconnecting member 106. In addition, in a single insulating pad group, in the direction away from the conductive block 103, the thicknesses of at least two insulating pads 114 along the third direction Z progressively decrease, which also helps to effectively reduce the overall amount of the insulating material required for the single insulating pad group so as to prevent warping of the back-contact photovoltaic module caused by volume shrinkage of the insulating material covering a large area.

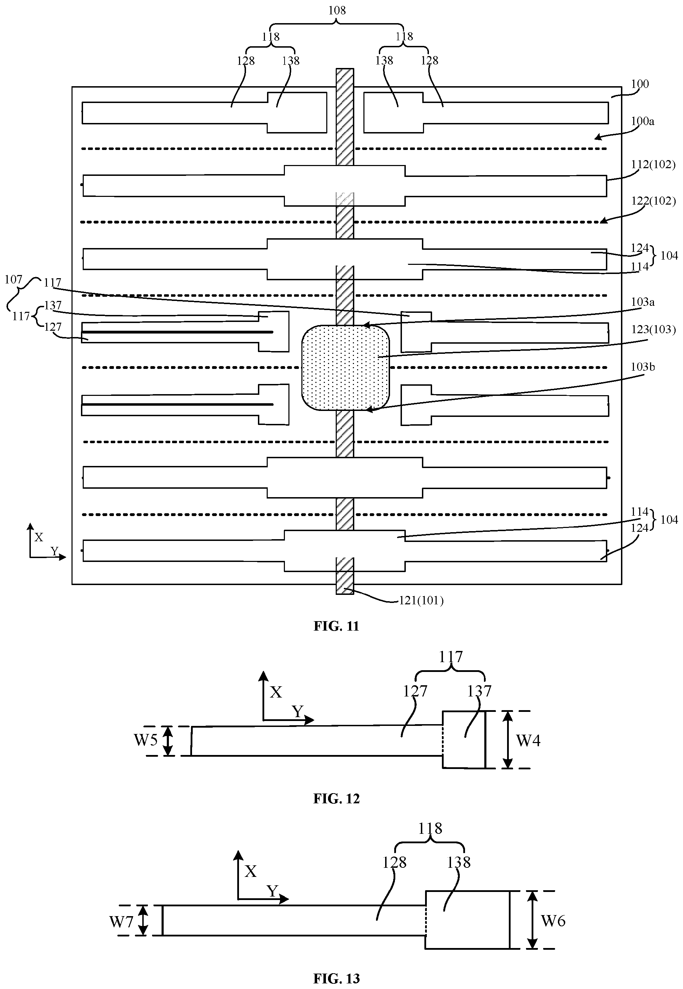

In some embodiments, as illustrated in FIG. 11, which is a sixth schematic partial top view of a back-contact photovoltaic module according to some embodiments of the present disclosure, the back-contact photovoltaic module may further include: at least two first insulating blocks 107 spaced apart along the first direction X. Each of the first insulating blocks 107 includes two first insulating sub-blocks 117 spaced apart along the second direction Y. A single first insulating sub-block 117 is disposed on one of two opposing sides of the conductive block 103 along the second direction Y, and covers at least a portion of one of two sections of a finger 102 disconnected by the conductive block 103. In other words, for a single conductive block 103, a first insulating block 107 is further arranged on a polarity-opposite finger 102 (i.e., a finger 102 electrically insulated from the conductive block 103) disposed on two opposing sides of the conductive block 103 along the second direction Y. The first insulating block 107 protects ends of the two sections of the finger 102 disconnected by the conductive block 103, so that an insulating material is present between the conductive block 103 and the portion of the finger 102. This further prevents the interconnecting member 106 from coming into contact with the finger 102 electrically insulated from the conductive block 103, and thus avoids the occurrence of short circuits in the back-contact photovoltaic module.

In some cases, along the second direction Y, the conductive block 103 is disposed between two adjacent first insulating sub-blocks 117, and the number of fingers 102 disconnected by the conductive block 103 may be 2, or may be 1, 3, or 4. The number of fingers 102 to be disconnected maybe selected based on the actual size of the conductive block 103.

In some cases, referring to FIG. 11 and FIG. 12, FIG. 12 is a schematic cross-sectional view of a first insulating sub-block in a back-contact photovoltaic module according to some embodiments of the present disclosure. The first insulating sub-block 117 includes a first extended portion 127 and a first widened portion 137 adjacent to the conductive block 103. The first widened portion 137 covers an end of one of two sections of the finger 102 disconnected by the conductive block 103. The first extended portion 127 is disposed on a side of the first widened portion 137 away from the conductive block 103. Along the first direction X, the first widened portion 137 has a fourth width W4, and the first extended portion 127 has a fifth width W5, where the fourth width W4 is greater than the fifth width W5. Thus, for each of the interconnecting members 106 and the conductive block 103 connected to the interconnecting member 106, not only is the interconnecting member 106 effectively prevented from coming into contact with the finger 102 electrically insulated from the conductive block 103 by virtue of the first widened portion 137, but also the protection for the finger 102 is enhanced by virtue of the first extended portion 127 having a smaller width than the first widened portion 137. In addition, the overall layout area of the first insulating sub-block 117 on the cell substrate 100 is reduced as much as possible. This prevents warping of the back-contact photovoltaic module caused by volume shrinkage of the insulating material covering a large area.

It should be noted that in FIG. 12, the first extended portion 127 and the first widened portion 137 included in the first insulating sub-block 117 are delineated by dashed lines.

In some embodiments, referring to FIG. 11, the back-contact photovoltaic module may further include: at least two second insulating blocks 108 spaced apart along the first direction X. Each of the second insulating blocks 108 includes two second insulating sub-blocks 118 spaced apart along the second direction Y. A single second insulating sub-block 118 covers at least a portion of one of two sections of the finger 102 disconnected by the busbar 101. In other words, for a single busbar 101, a second insulating block 108 is further arranged on a polarity-opposite finger 102 (i.e., a finger 102 electrically insulated from the busbar 101) disposed on two opposing sides of the busbar 101 along the second direction Y. The second insulating block 108 protects ends of the two sections of the finger 102 disconnected by the busbar 101, so that an insulating material is present between the busbar 101 and the portion of the finger 102. This further prevents the interconnecting member 106 from coming into contact with the finger 102 electrically insulated from the busbar 101, and thus avoids the occurrence of short circuits in the back-contact photovoltaic module.

In some cases, referring to FIG. 13, which is a schematic cross-sectional view of a second insulating sub-block in a back-contact photovoltaic module according to some embodiments of the present disclosure. The second insulating sub-block 118 includes a second extended portion 128 and a second widened portion 138 adjacent to the busbar 101. The second widened portion 138 covers an end of one of two sections of the finger 102 disconnected by the busbar 101. The second extended portion 128 is disposed on a side of the first widened portion 138 away from the busbar 101. Along the first direction X, the second widened portion 138 has a sixth width W26, and the second extended portion 128 has a seventh width W7, where the sixth width W26 is greater than the seventh width W7. Thus, for each of the busbars 101 and the conductive block 103 connected to the busbar 101, not only is the busbar 101 effectively prevented from coming into contact with the finger 102 electrically insulated from the conductive block 103 by virtue of the second widened portion 138, but also the protection for the finger 102 is enhanced by virtue of the second extended portion 128 having a smaller width than the second widened portion 138. In addition, the overall layout area of the second insulating sub-block 118 on the cell substrate 100 is reduced as much as possible. This prevents warping of the back-contact photovoltaic module caused by volume shrinkage of the insulating material covering a large area.

It should be noted that in FIG. 13, the second extension portion 128 and the second widened portion 138 included in the second insulating sub-block 118 are delineated by dashed lines.

In some embodiments, along the first direction X, the fourth width W4 of the first widened portion 137 may be less than the sixth width W6 of the second widened portion 138. The first widened portion 137 is closer to the conductive block 103 than the second widened portion 138. By designing the fourth width W4 of the first widened portion 137 to be smaller, not only is the first insulating sub-block 117 prevented from overflowing onto the conductive block 103, but also the overall layout area of the first insulating sub-block 117 on the cell substrate 100 is reduced.

In some embodiments, along the second direction Y, the length of the first widened portion 137 may be less than the length of the second widened portion 138. The first widened portion 137 is closer to the conductive block 103 than the second widened portion 138. By designing the first widened portion 137 to be shorter, not only is the first insulating sub-block 117 prevented from overflowing onto the conductive block 103, but also the overall layout area of the first insulating sub-block 117 on the cell substrate 100 is reduced.

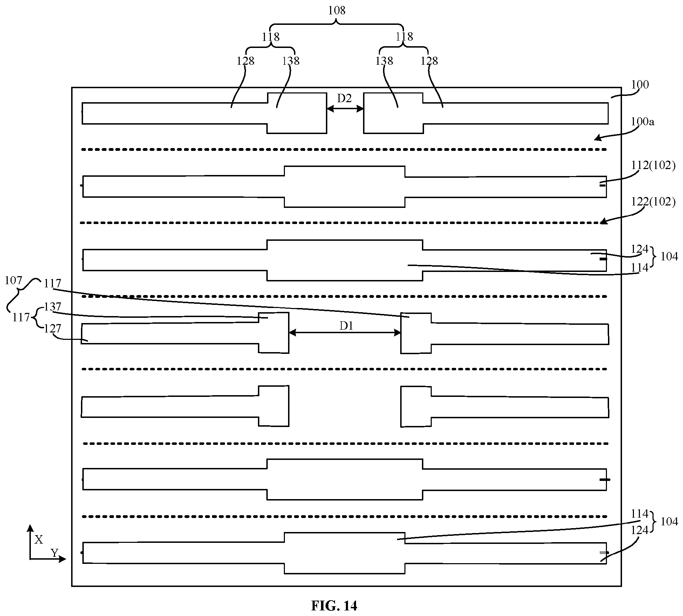

In some embodiments, referring to FIG. 14, which is a schematic partial top view of an insulating structure corresponding to a finger in a back-contact photovoltaic module according to some embodiments of the present disclosure, along the second direction Y, a spacing between two first insulating sub-blocks 117 in the same first insulating block 107 is a first spacing D1, and a spacing between two second insulating sub-blocks 118 in the same second insulating block 108 is a second spacing D2. The first spacing D1 is greater than the second spacing D2. Thus, compared with the extension length of the finger 102 disconnected by the conductive block 103 along the second direction Y, the extension length of the finger 102 disconnected by the busbar 101 along the second direction Y can be increased as large as possible under the protection of the second insulating sub-block 118. This allows for the effective collection of photogenerated carriers in more regions on a cell body 10 by the finger 102, and the carriers are then collected by the interconnecting member 106, so that the photovoltaic conversion efficiency of the back-contact photovoltaic module is further enhanced.

It should be noted that the insulating structure in FIG. 14 includes, but is not limited to, the insulating member 104, the first insulating block 107, and the second insulating block 108. In addition, FIG. 5 further illustrates a bridge finger 105 based on the structure illustrated in FIG. 1. In practice, a bridge finger may be added to the structure illustrated in FIG. 6, FIG. 8, or FIG. 11. FIG. 6 further illustrates an extended portion 134 added to an insulating member 104 based on the structure illustrated in FIG. 1. In practice, an extended portion may be added to an insulating member based on the structure illustrated in FIG. 5, FIG. 8, or FIG. 11.

In some examples, the first spacing D1 may be 1.3 mm, and the second spacing D2 may be 0.42 mm.

In some examples, along the first direction X, a plurality of fingers 102 are disconnected by the busbar 101. The fingers 102 adjacent to two opposing sides of the conductive block 103 along the first direction X are protected by the insulating members 104, while the fingers 102 away from the insulating pad group are protected by the second insulating sub-blocks 118. A single second insulating block 108 includes two second insulating sub-blocks 118 disposed adjacent to each other along the second direction Y on both sides of the busbar 101. A plurality of second insulating blocks 108 may be spaced apart along the first direction X, and the second spacing D2 between two adjacent second insulating sub-blocks 118 in each of the plurality of second insulating blocks 108 may progressively increase to further reduce the total layout area of the second insulating sub-blocks 118 on the cell substrate 100.

In some embodiments, the cell substrate 100 is a back-contact (BC) cell, which includes, but is not limited to, an interdigitated back-contact (IBC) cell, a heterojunction back-contact (HBC) cell, a TOPCon back-contact (TBC) cell, or a hybrid passivated back-contact (HPBC) cell. Further, the cell substrate 100 may be a full-cell or a split-cell, where the split-cell is formed by subjecting an intact full-cell to a dicing process.

In some embodiments, the back-contact photovoltaic module further includes an encapsulation layer. The encapsulation layer covers the surface of the cell substrate 100. The encapsulation layer may be made of a polyvinyl butyral (PVB) adhesive film, an ethylene-vinyl acetate (EVA) adhesive film, a polyethylene octene co-elastomer (POE) adhesive film, or a polyethylene terephthalate (PET) adhesive film. Alternatively, the encapsulation layer may be an EP adhesive film, an EPE adhesive film, or a PVP adhesive film. The EP adhesive film refers to a co-extruded adhesive film formed by laminating an EVA adhesive film and a POE adhesive film, the EPE adhesive film refers to a co-extruded adhesive film formed by sequentially laminating an EVA adhesive film, a POE adhesive film, and an EVA adhesive film, and the PVP adhesive film refers to a co-extruded adhesive film formed by laminating a POE adhesive film, an EVA adhesive film, and a POE adhesive film. The method for preparing a co-extruded adhesive film may involve sequentially extruding one or more raw materials onto a pre-formed adhesive film, or bonding different types of pre-formed adhesive films together.

In some embodiments, the back-contact photovoltaic module further includes a cover plate, which is disposed on a surface of the encapsulation layer away from the cell substrate 100. The cover plate may be a glass cover plate, a plastic cover plate, or any other cover plate that has a light transmission function and is not easily damaged. In some embodiments, a surface of the cover plate facing the encapsulation layer may be a concave-convex surface or a textured surface including a plurality of protrusion structures, thereby increasing the utilization of incident light.

In summary, each of the insulating members 104 is designed to include an insulating pad 114 and at least one extension member 124. The insulating pad 114 at least covers a portion of the busbar 101 connected to the conductive block 103. In this way, the insulating pad 114 not only protects the portion of the busbar 101 to reduce the risk of fracture of the busbar 101, but also provides a higher support point for the interconnecting member 106. On one hand, this design helps to avoid excessive local bending of the welding strip 136, thereby reducing the risk that the interconnecting member 106 applies a large stress to the adjacent busbar 101 and finger 102, which could lead to fracture of the adjacent busbar 101 and finger 102. On the other hand, the insulating pad 114 covering the busbar 101 helps to avoid that the molten material of the interconnecting member 106 drips on the busbar 101 under high-temperature conditions and causes fracture of the busbar 101, thereby further reducing the risk of fracture of the busbar 101. In addition, the extension member 124 covers a portion of the finger 102 disconnected by the busbar 101, which facilitates ensuring that the interconnecting member 106 subsequently connected to the conductive block 103 does not come into contact with a disconnected end of a polarity-opposite finger, so that short circuits between the first fingers 112 and the second fingers 122 are prevented. Furthermore, the second width W2 of the extension member 124 is designed to be less than the first width W1 of the insulating pad 114, which helps to reduce the amount of the insulating material required for forming the extension member 124 and avoid warping of the back-contact photovoltaic module caused by volume shrinkage of the insulating material covering a large area, while enhancing an insulating effect of the insulating member 104 on the covered finger 102 by virtue of the extension member 124. Therefore, under the multifaceted effects of the insulating members 104, it is not only conductive to preventing short circuits between the first fingers 112 and the second fingers 122, as well as reducing the risk of fracture of the fingers 102 or the busbars 101, but also conductive to reduce the bending degree of the interconnecting members 106 so as to reduce the stress exerted by the interconnecting members 106 on the cell substrate 100 so that the structural stability of the back-contact photovoltaic module is significantly enhanced.

Some embodiments of the present disclosure provide a back-contact photovoltaic module. The back-contact photovoltaic module according to the embodiments of the present disclosure is described in detail with reference to the accompanying drawings.

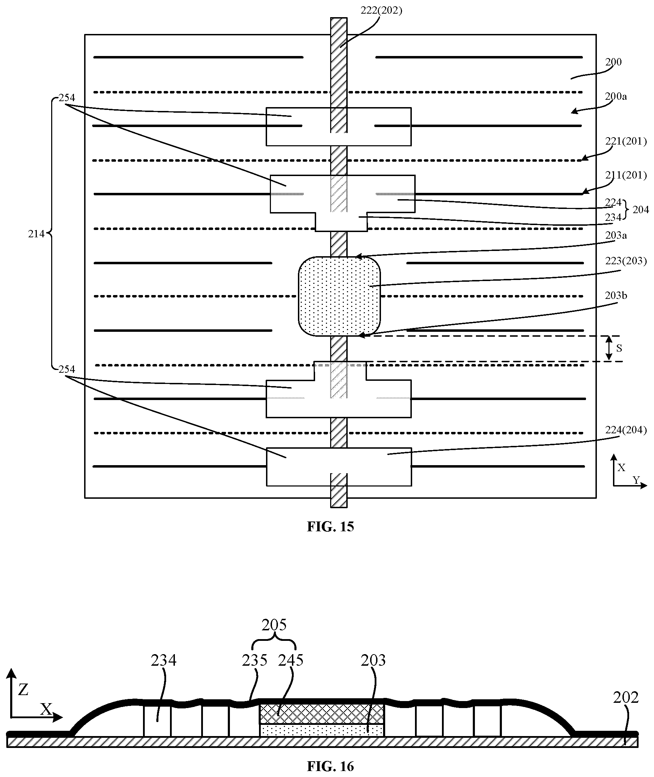

Referring to FIG. 15 to FIG. 17, the back-contact photovoltaic module includes: a cell substrate 200, a plurality of conductive blocks 203, and a plurality of insulating members 204. First fingers 211 and second fingers 221 are alternatingly arranged on a back surface 200a of the cell substrate 200. First busbars 212 and second busbars 222 are alternatingly arranged on the back surface 200a of the cell substrate 200 along a second direction Y. Each of the first fingers 211 is disconnected at the second busbars 222, and each of the second fingers 221 is disconnected at the first busbars 212. A respective conductive block 203 is disposed at a disconnected position of a respective first finger 211 and connected to a respective second busbar 222, or is disposed at a disconnected position of a respective second finger 221 and connected to a respective first busbar 212. The plurality of insulating members 204 extend along the second direction Y. At least two insulating members 204 serve as one first insulating group 214. Each respective first insulating group 214 is provided for one respective conductive block 203. In the respective first insulating group 214, the at least two insulating members 204 are respectively disposed on two opposing sides of the respective conductive block 203 along the first direction X. Each insulating member 204 at least includes an insulating pad 224 covering a portion of a respective busbar 202 connected to the conductive block 203 and covering two ends of two sections of a finger 201 disconnected by the respective busbar 202. The busbar 202 is one of the first busbar 212 and the second busbar 222, and the finger 201 is one of the first finger 211 and the second finger 221. Each of at least one insulating member 204 adjacent to the conductive block 203 further includes an extended portion 234 protruding toward the conductive block 203, where the extended portion 234 covers a portion of one finger 201 disposed between the conductive block 203 and the insulating member 204.

It should be noted, based on different polarities, the fingers 201 may be categorized into first fingers 211 and second fingers 221. Likewise, the busbars 202 may be categorized into first busbars 212 and second busbars 222. The first busbars 212 are configured to collect currents on all the first fingers 211, and the second busbars 222 are configured to collect currents on all the second fingers 221. Similarly, the plurality of conductive blocks 203 may include first conductive blocks 213 and second conductive blocks 223. The first conductive blocks 213 are disposed at disconnected positions of the second fingers 221 and connected to the first busbars 212, and the second conductive blocks 223 are disposed at disconnected positions of the first fingers 211 and connected to the second fingers 222. The disconnected positions of the second fingers 221 are configured to allow the first busbars 212 to extend along the first direction X and to be electrically connected to a plurality of first fingers 211. The disconnected positions of the first fingers 211 are configured to allow the second busbars 222 to extend along the first direction X and to be electrically connected to a plurality of second fingers 221.

Furthermore, based on the types of the connected conductive blocks 203, interconnecting members 205 described hereinafter may be categorized into first interconnecting members 215 and second interconnecting members 225. The first interconnecting members 215 come into contact with the first conductive blocks 213 to collect currents on the first busbars 212, and the second interconnecting members 225 come into contact with the second conductive blocks 223 to collect currents on the second busbars 222.

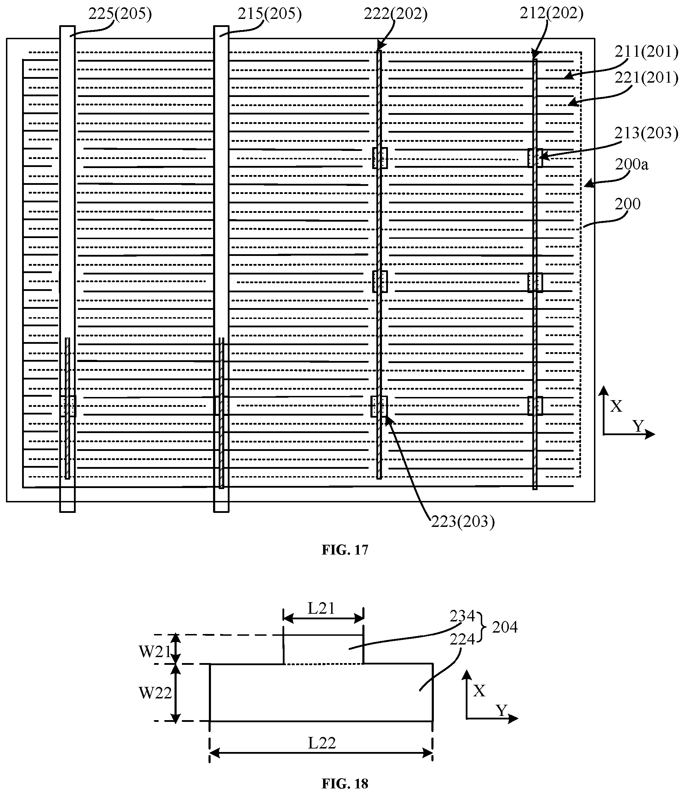

It should be noted that FIG. 15 is a seventh schematic partial top view of a back-contact photovoltaic module according to some embodiments of the present disclosure, FIG. 16 is a schematic partial cross-sectional view of a back-contact photovoltaic module according to some embodiments of the present disclosure, and FIG. 17 is an eighth schematic partial top view of a back-contact photovoltaic module according to some embodiments of the present disclosure. For differentiation between the first finger 211 and the second finger 221, FIG. 15 and FIG. 16 illustrate the first finger 211 with a thicker solid line and the second finger 221 with a thicker dashed line. In FIG. 15, the insulating member 204 is depicted in a perspective view. In addition, similar to the case where the "finger 201" refers to either the first finger 211 or the second finger 221, and "busbar 202" refers to either the first busbar 212 or the second busbar 222, the conductive block 203 described in the subsequent paragraphs may refer to either a first conductive block 213 or a second conductive block 223. Similarly, the interconnecting member 205 may refer to either a first interconnecting member 215 or a second interconnecting member 225.

Furthermore, for clearer illustration of a positional relationship between the busbar 202, the finger 201, and the conductive block 203, FIG. 17 illustrates only two interconnecting members 205, with the interconnecting members 205 depicted in a perspective view.

It should be noted, in the back-contact photovoltaic module according to some embodiments of the present disclosure, special design considerations are made for insulating strips with respect to the surrounding area of the conductive blocks 203. Specifically, first insulating groups 214 in one-to-one correspondence with the conductive blocks 203 are provided, and in a single insulating group 214, at least two insulating members 204 are designed to be disposed on two opposing sides of a conductive block 203 along the first direction X. That is, at least one insulating member 204 is arranged on each of the two opposing sides of the conductive block 203 along the first direction X. Furthermore, each of the insulating members 204 at least includes an insulating pad 224. The insulating pad 224 covers not only a portion of the busbar 202 connected to the conductive block 203 but also covers two ends of two sections of the finger 201 disconnected by the busbar 202. In other words, in the vicinity of the conductive block 203, the insulating member 204 also covers a disconnected end of a finger 201 which is disconnected by the busbar 202 electrically connected to the conductive block 203.

In this way, the insulating pads 224 not only ensure that the interconnecting members 205 subsequently connected to the conductive blocks 203 do not come into contact with disconnected ends of polarity-opposite fingers, avoiding short circuits between the first fingers 211 and the second fingers 221, but also provide higher support points for the interconnecting members 205.

In some cases, with reference to FIG. 16 and FIG. 17, the interconnecting member 205 includes a welding strip 235 and a solder paste 245. In connecting, for example, welding the interconnecting member 205 to the conductive block 203, the solder paste 245 in the interconnecting member 205 allows electrical connection of the welding strip 235 to the conductive block 203. However, along the third direction Z, the conductive block 203 is disposed on the busbar 202, and due to the solder paste 245 in the interconnecting member 205, a height difference is present between the interconnecting member 205 and the busbar 202. The insulating pad 224 is designed to be also disposed on the busbar 202 so that a larger area of the subsequently formed interconnecting member 205 is supported by higher support points along the second direction Y. In other words, not only a portion of the welding strip 235 in contact with the conductive block 203 in the interconnecting member 205 is elevated, and but alsoa portion of the welding strip 235 in contact with the insulating pad 224 is also elevated, so that an elevated portion of the welding strip 235 as a whole is increased. On one hand, this helps to avoid excessive local bending of the welding strip 235, that is, from the perspective of the entire interconnecting member 205, the bending degree of the welding strip 235 per unit length is reduced, instead of the case where only the portion of the welding strip 235 connected to the conductive block 203 is elevated. In other words, this helps to slow a bending tendency of the welding strip 235. On the other hand, avoiding excessive local bending of the welding strip 235 helps to reduce the risk that the interconnecting member 205 applies large stress to the adjacent busbar 202 and finger 201, so that the busbar 202 and the finger 201 are not susceptible to fracture. In addition, the insulating pad 224 covering the busbar 202 helps to avoid that the molten material of the interconnecting member 205 drips on the busbar 202 under high-temperature conditions and causes the busbar 202 to fracture, thereby further reducing the risk of fracture of the busbar 202. The third direction Z is a thickness direction of the cell substrate 200. It is worth emphasizing that the bending degree of the interconnecting member 205 described in the subsequent paragraphs primarily refers to the bending degree of the welding strip 235 in the interconnecting member 205.

Moreover, each of at least one insulating member 204 adjacent to the conductive block 203 is designed to further include an extended portion 234 protruding toward the conductive block 203. The extended portion 234 covers a portion of one finger 201 disposed between the conductive block 203 and the insulating member 204. In other words, the extended portion 234 covers a portion of the finger 201 adjacent to and electrically connected to the conductive block 203. Since the finger 201 is closest to the conductive block 203, when the interconnecting member 205 is connected, for example, welded to the conductive block 203, the portion of the interconnecting member 205 directly above the finger 201 is more affected by the temperature. Designing the extended portion 234 to cover the finger 201 effectively prevents fracture of the finger 201 at this position.

In summary, under the multifaceted effects of the insulating members 204, it is not only conductive to reducing the risk of fracture of the fingers 201 or the busbars 202, but also conductive to reduce the bending degree of the interconnecting members 205 so as to reduce the stress exerted by the interconnecting members 205 on the cell substrate 200 so that the structural stability of the back-contact photovoltaic module is significantly enhanced.

It is worth emphasizing that each first insulating member 204 includes an insulating pad 224, and the insulating pad 224 covers only one finger 201 disconnected by the busbar 202, and that the insulating members 204 are disposed only on some of fingers 201 adjacent to the conductive block 203 along the first direction X. In this way, compared with laying the insulating material in a large area around the conductive block, this design is conducive to ensuring that the insulating member 204 covers areas of the busbar 202 and the finger 201 that are more susceptible to fracture, to reduce the risk of fracture of the busbar 202 and the finger 201. In addition, this design helps to reduce the bending degree of the interconnecting member 205 subsequently electrically connected to the conductive block 203, while reducing a total layout area occupied by the insulating member 204 on the cell substrate 200 to reduce the amount of the insulating material required for forming the insulating member 204. In this way, the preparation cost of the insulating member 204 is reduced, and warping of the back-contact photovoltaic module caused by volume shrinkage of the insulating material covering a large area is prevented.

In addition, each insulating member 204 includes an insulating pad 224. However, only some of insulating members 204 further include an extended portion 234. For example, only an insulating member 204 closest to the conductive block 203 along the first direction X includes the extended portion 234. In a single first insulating group 214, only two insulating members 204 each include the extended portion 234, and are disposed on opposing sides of the conductive block 203 along the first direction X. In this way, the risk of fracture of a finger 201 closest to the conductive block 203 can be effectively reduced, while the total layout area of the insulating member 204 on the battery substrate 200 is minimized.

The embodiments of the present disclosure are described in detail hereinafter with reference to the accompanying drawings.

In some embodiments, with reference to FIG. 15 and FIG. 17, the back-contact photovoltaic module may further include: a plurality of interconnecting members 205 spaced apart along the second direction Y. Each respective interconnecting member 205 is disposed on one respective busbar 202, and the respective interconnecting member 205 is connected to at least the conductive block 203. The extended portion 234 covers a portion of the busbar 202 connected to the conductive block 203, and with the plane formed by the first direction X and the second direction Y as a reference plane, for the extended portion 234 and the interconnecting member 205 corresponding to the same busbar 202, an orthogonal projection of the extended portion 234 on the reference plane is overlapped with an orthogonal projection of the interconnecting member 205 on the reference plane.

It should be noted when the interconnecting member 205 is bonded (e.g., welded) to the conductive block 203, both the finger 201 and the busbar 202 that are adjacent to the conductive block 203 are susceptible to being affected by the molten material of the interconnecting member 205 under high-temperature conditions. Therefore, the extended portion 234 is designed to not only cover a portion of a finger 201 closest to the conductive block 203 and electrically connected to the conductive block 203, but also cover a portion of the busbar 202 connected to the conductive block 203, which is conducive to simultaneously protect, with the extended portion 234, the portions of both the busbar 202 and the finger 201 that are susceptible to fracture, and thus the structural stability of the back-contact photovoltaic module is further improved.

In general, the finger 201 and the busbar 202 disposed directly beneath the interconnecting member 205 are most susceptible to being affected by the molten raw material of the interconnecting member 205 under high-temperature conditions. Therefore, by designing the extended portion 234 and the interconnecting member 205 corresponding to the same busbar 202 such that the orthogonal projection of the extended portion 234 on the reference plane is overlapped with the orthogonal projection of the interconnecting member 205 on the reference plane, it is conducive to ensuring that at least a portion of the area directly beneath the interconnecting member 205 is covered by the extended portion 234. This ensures that the extended portion 234 precisely protects the finger 201 and the busbar 202.

It should be noted that the orthogonal projection of the extended portion 234 on the reference plane being overlapped with the orthogonal projection of the interconnecting member 205 on the reference plane includes at least the following cases. In some cases, the orthogonal projection of the extended portion 234 on the reference plane is within the orthogonal projection of the interconnecting member 205 on the reference plane. In other cases, the orthogonal projection of the interconnecting member 205 on the reference plane is within the orthogonal projection of the extended portion 234 on the reference plane. In yet other cases, the orthogonal projections of the extended portion 234 on the reference plane is only partially overlapped with the interconnecting member 205 on the reference plane.

In some embodiments, referring to FIG. 18, which is a schematic top view of an insulating member in a back-contact photovoltaic module according to some embodiments of the present disclosure, along the second direction Y, the extended portion 234 has a first length L21, and the insulating pad 224 has a second length L22. A ratio of the first length L21 to the second length L22 may range from 1:5 to 1:2. For example, the ratio of the first length L21 to the second length L22 may be 1:4, 3:10, 1:3, or 2:5.

Referring to FIG. 15 and FIG. 18, in a case where the ratio of the first length L21 to the second length L22 is less than 1:5, an area of the finger 201 adjacent to the conductive block 203 covered by the extended portion 234 is small, which is not conducive to improving the protective effect of the extended portion 234 on the finger 201. In a case where the ratio of the first length L21 to the second length L22 is greater than 1:2, the total layout area of the extended portion 234 on the cell substrate 200 becomes large, which may affect the total layout area of the insulating member 204 on the cell substrate 200. This is not conducive to both reducing the volume of the insulating member 204 and preventing warping of the back-contact photovoltaic module. Thus, designing the ratio of the first length L21 to the second length L22 to be between 1:5 and 1:2 is conducive to ensuring that the extended portion 234 provides good protection for the finger 201, so that the risk of fracture of the finger 201 is effectively reduced while the volume of the insulating member 204 is also reduced to prevent severe warping of the back-contact photovoltaic module.

It should be noted that in FIG. 18, the extension portion 234 and the insulating pad 224 included in the insulating member 204 are delineated by dashed lines.

In some examples, along the second direction Y, the first length L21 of the extended portion 234 may be greater than or equal to 0.20 mm. For example, the first length L21 may be 0.25 mm, 0.3 mm, 0.35 mm, 0.4 mm, 0.42 mm, 0.45 mm, or 0.5 mm, to ensure that the extended portion 234 provides good protection for the finger 201.

In some examples, along the second direction Y, the second length L22 of the insulating pad 224 may range from 1 mm to 9 mm. For example, the second length L22 may be 1.5 mm, 1.8 mm, 2 mm, 2.5 mm, 3 mm, 3.5 mm, 4 mm, 4.5 mm, 5 mm, 5.5 mm, 6 mm, 6.5 mm, 7 mm, 7.5 mm, 8 mm, or 8.5 mm.

With reference to FIG. 15 and FIG. 18, in a case where the second length L22 is less than 1 mm, the insulating pad 224 is shorter, and the support strength of the insulating pad 224 for the interconnecting member 205 (referring to FIG. 17) may be limited. When the interconnecting member 205 is placed on the conductive block 203 and connected, for example, welded to the conductive block 203, due to a small support area of the insulating pad 224 for the interconnecting member 205, the interconnecting member 205 is susceptible to instability, such as tilting, leading to relative displacement between the interconnecting member 205 and the conductive block 203. Moreover, the shorter insulating pad 224 provides a poor stress buffering effect, leading to larger local stress exerted on the cell substrate 200 during welding. In a case where the second length L22 is greater than 9 mm, of the insulating pad 224 is longer, and the overall layout area of the insulating pad 224 on the cell substrate 200 is increased. This may affect the total layout area of the insulating member 204 on the cell substrate 200, which is not conducive to both reducing the volume of the insulating member 204 and preventing warping of the back-contact photovoltaic module. Thus, designing the second length L22 to range from 1 mm to 9 mm is conducive to ensuring that the insulating pad 224 provides a sufficient support strength for the interconnecting member 205 and offers a good stress buffering effect. This helps to effectively prevent relative displacement of the interconnecting member 205 and the conductive block 203, and stress concentration, while reducing the volume of the insulating member 204 to prevent significant warping of the back-contact photovoltaic module.

It should be noted that along the second direction Y, in different insulating members 204, the ratios of the length of the extended portion 234 to the length of the insulating pad 224 may be the same or different. In different insulating members 204, the lengths of different extended portions 234 may be the same or different. In different insulating members 204, the lengths of different insulating pads 224 may be the same or different.

In some embodiments, still referring to FIG. 18, along the first direction X, the extended portion 234 has a first width W21, and the insulating pad 224 has a second width W22. A ratio of the first width W21 to the second width W22 ranges from 1:2 to 1:1. For example, the ratio of the first width W21 to the second width W22 may be 3:5, 7:10, 4:5, or 9:10.

It should be noted, with reference to FIG. 15 and FIG. 18, in the same insulating member 204, the ratio of the first width W21 to the second width W22 represents the protrusion magnitude of the extended portion 234 relative to the insulating pad 224. In a case where the ratio of the first width W21 to the second width W22 is less than 1:2, the protrusion magnitude of the extended portion 234 protrudes relative to the extended portion 224 is smaller, resulting a smaller width of the portion of the extended portion 234 between the conductive block 203 and the finger 201 closest to the conductive block 203. In addition, this portion of the extended portion 234 is disposed at the edge of the insulating member 104, where edge thinning susceptibility arises from adhesive overflow, which affects the thickness of the extended portion 234 around the finger 201 and thus weakens the protective effect of the extended portion 234 on the finger 201. In a case where the ratio of the first width W21 to the second width W22 is greater than 1:1, the protrusion magnitude of the extended portion 234 relative to the extended portion 224 is greater. In this case, the gap between the extended portion 234 and the conductive block 203 becomes smaller, and the insulating material forming the extended portion 234, such as insulating adhesive, is more prone to overflow onto the conductive block 203. When welding the interconnecting member 205 (referencing FIG. 17) onto the conductive block 203, the raw material of the interconnecting member 205, such as a solder paste, may be divided into two parts due to overflow of the insulating adhesive on the conductive block 203 resulting in poor contact between the interconnecting member 205 and the conductive block 203.

Thus, designing the ratio of the first width W21 to the second width W22 to range from 1:2 to 1:1 is conducive to ensuring that the thickness of the extended portion 234 around the finger 201 is not too small, so that the extended portion 234 achieves a good protective effect on the finger 201, and an appropriate gap is present between the extended portion 234 and the conductive block 203. This effectively prevents the insulating material forming the extended portion 234 from overflowing onto the conductive block 203, and hence prevents poor contact between the interconnecting member 205 and the conductive block 203.

In some examples, along the first direction X, the first width W21 of the extended portion 234 may range from 0.2 mm to 0.3 mm, for example, 0.22 mm, 0.24 mm, 0.25 mm, 0.26 mm, or 0.28 mm. The second width W22 of the insulating pad 224 may range from 0.3 mm to 0.5 mm, for example, 0.32 mm, 0.34 mm, 0.35 mm, 0.36 mm, 0.38 mm, 0.4 mm, 0.42 mm, 0.44 mm, 0.45 mm, 0.46 mm, or 0.48 mm.

It should be noted that along the first direction X, in different insulating members 204, the ratios of the width of the extended portion 234 to the width of the insulating pad 224 may be the same or different. In different insulating members 204, the widths of different extended portions 234 may be the same or different. In different insulating members 204, the widths of different insulating pads 224 may be the same or different.

In some embodiments, referring to FIG. 15, the conductive block 203 has two opposing sides along the first direction X, i.e., an upper side 203a and a lower side 203b. One insulating member 204, which is closest to the upper side 203a and/or the lower side 203b, includes an insulating pad 224 and an extended portion 234. Along the first direction X, a spacing S between the conductive block 203 and the extended portion 234 is greater than or equal to 0.20 mm.

It should be noted that, in FIG. 15, it is shown as an example that one insulating member 204 closest to the upper side 203a includes both the insulating pad 224 and the extended portion 234, and the insulating member 204 closest to the lower side 203b also includes both the insulating pad 224 and the extended portion 234. In practice, it is also possible that only one insulating member closest to the upper side includes both the insulating pad and the extended portion, whereas the other insulating members do not include the extended portion. Alternatively, only one insulating member closest to the lower side includes both the insulating pad and the extended portion, whereas the other insulating members do not include the extended portion.

It is worth emphasizing that along the first direction X, the spacing S between the conductive block 203 and the extended portion 234 is greater than or equal to 0.20 mm. For example, the spacing S may be 0.25 mm, 0.3 mm, 0.35 mm, 0.4 mm, 0.42 mm, 0.45 mm, or 0.5 mm, etc. This helps to effectively prevent the insulating material constituting the extended portion 234 from overflowing onto the conductive block 203, thereby avoiding poor contact between the interconnecting member 205 and the conductive block 203, and enhancing the structural stability of the back-contact photovoltaic module.

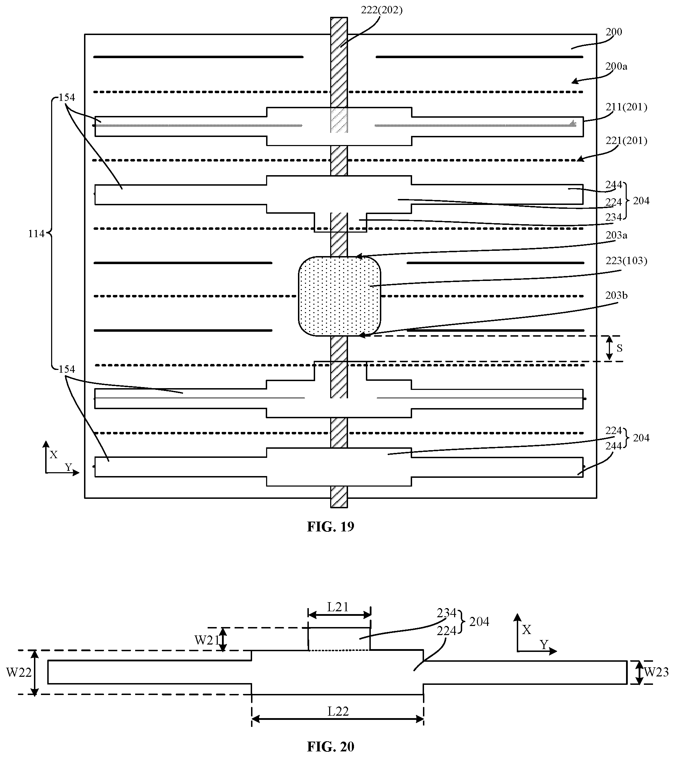

In some embodiments, with reference to FIG. 19 and FIG. 20, each of the insulating members 204 at least include an insulating pad 224 and at least one extension member 244. A single extension member 244 is connected to one of two opposite ends of the insulating pad 224 along the second direction Y. In this case, along the first direction X, the insulating pad 224 has a second width W22, and the extension member 244 has a third width W23. The second width W22 is greater than the third width W23.

It should be noted that each of the insulating members 204, regardless of whether the insulating member 204 includes an extended portion 234, always includes an insulating pad 224 and at least one extension member 244, and only some of the insulating members 204 include an extended portion 234. Furthermore, the third width W23 of the extension member 244 is designed to be less than the second width W22 of the insulating pad 224. This helps to reduce the amount of the insulating material required for forming the extension member 244 to reduce the amount of the insulating material required for forming the insulating member 204, while enhancing an insulating effect of the insulating member 244 on the covered finger 201 by virtue of the extension member 244. In this way, the preparation cost of the insulating member 204 is reduced, and warping of the back-contact photovoltaic module caused by volume shrinkage of the insulating material covering a large area is prevented.

FIG. 19 is a ninth schematic partial top view of a back-contact photovoltaic module according to some embodiments of the present disclosure, and FIG. 20 is another schematic top view of an insulating member in a back-contact photovoltaic module according to some embodiments of the present disclosure. It should be noted that the same or similar parts in FIG. 19 and FIG. 15 are not repeated herein, and the same or similar parts in FIG. 20 and FIG. 18 are not repeated herein either.

In some cases, referring to FIG. 19 and FIG. 20, each insulating member 204 includes one insulating pad 224 and two extension members 244. The two extension members 244 are respectively connected to two opposite ends of the insulating pad 224 along the second direction Y to improve the integrity and symmetry of the insulating effect of the insulating member 204 on the finger 201 covered. In other cases, each insulating member may include one insulating pad and one extension member. The extension member is connected to one of two opposite ends of the insulating pad along the second direction.

In some embodiments, referring to FIG. 15 or FIG. 19, two opposing sides of the conductive block 203 along the first direction X are an upper side 203a and a lower side 203b, and the number of insulating pads 224 spaced apart and adjacent to one of the upper side 203a and the lower side 203b ranges from 1 to 6. In other words, at least two insulating pads 224 spaced apart and adjacent to one of two opposing sides of the conductive block 203 along the first direction X are considered as one insulation structure group 254. The number of insulating pads 224 included in a single insulation structure group 254, i.e., the number of insulating members 204, ranges from 1 to 6. Thus, the number of insulating pads 224, i.e., the number of insulating members 204, in a single first insulating group 214 may range from 2 to 12.

It should be noted during the process of welding the interconnecting member 205 to the conductive block 203, the portion of the interconnecting member 205 adjacent to the conductive block 203 is more affected by temperature. By disposing the insulating pad 224 over the busbar 202 aligned along the third direction Z with the portion of the interconnecting member205 most affected by temperature and the polarity-opposite finger 201 electrically insulated from the busbar 202, the risk of fracture of the finger 201 and the busbar 202 can be significantly reduced, and the bending degree of the interconnecting member 205 caused by a height difference between the conductive block 203 and the busbar 202can be significantly reduced. In this way, there is no need to design the insulating members 204 with the insulating pad 224 in a region away from the conductive block 203. In other words, by designing the number of insulating pads 224 spaced apart and adjacent to at least one of the upper side 203a and the lower side 203b to range from 1 to 6, the risk of fracture of the finger 201 and the busbar 202 can be significantly reduced, and the bending degree of the welding strip 205 can be notably mitigated. In addition, this approach prevents an excessive number of insulating pads 224 which results in an increase in the total layout area of the insulating member 204 on the cell substrate 200.

It should be noted that in FIG. 15 and FIG. 19, the number of insulating pads 224 in a single insulation structure group 254 is shown as 2 for example. In practices, the number of insulating pads in a single insulation structure group may also be 1, 3, 4, 5, or other values.

In some cases, the number of insulating pads 224 spaced apart and adjacent to the upper side 203a may be equal to the number of insulating pads 224 spaced apart and adjacent to the lower side 203b, which is conducive to causing the region of the interconnecting member 205 adjacent to the upper side 203a and away from the lower side 203b to be elevated by the insulating pad 224 to a height that is nearly identical to a height to which the region of the interconnecting member 205 adjacent to the lower side 203b and away from the upper side 203a is elevated by the insulating pad 224. This is more conducive to assisting the gradual change in the extending of bending of the interconnecting member 205. In one example, the conductive block 203 may have a centerline extending along the second direction Y, and the insulation structure group 254 adjacent to the upper side 203a and away from the lower side 203b may be axially symmetric with the insulation structure group 254 adjacent to the lower side 203b and away from the upper side 203a about the centerline.

It should be noted that, in practice, the number of insulating pads 224 spaced apart and adjacent to the upper side 203a may be different from the number of insulating pads 224 spaced apart and adjacent to the lower side 203b, which can adjusted according to actual needs.

The following provides detailed description of the design of lengths of a plurality of insulating pads 204 along the second direction Y within a single first insulating group 214.

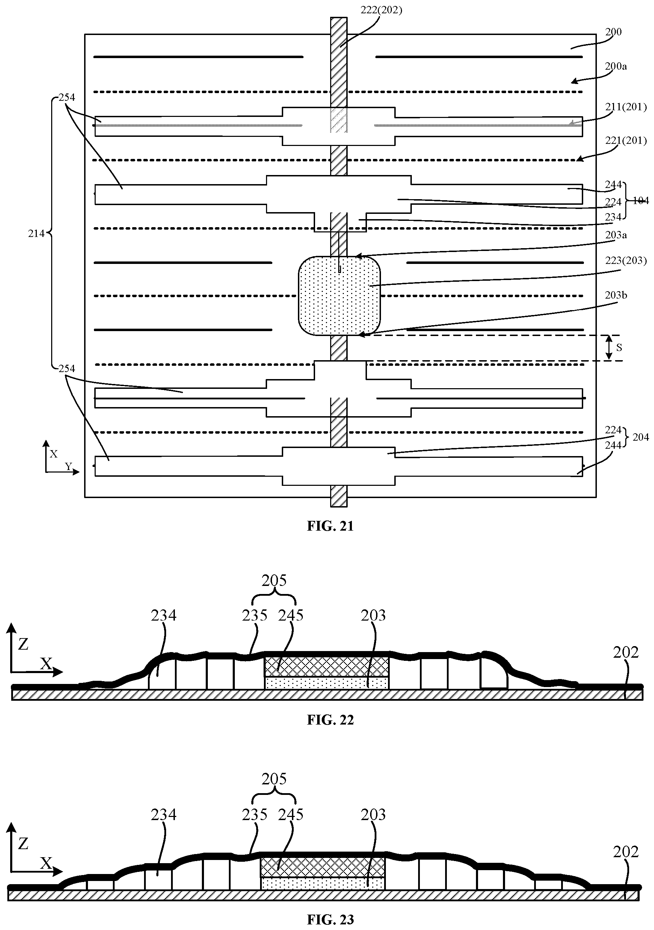

In some embodiments, referring to FIG. 21, FIG. 21 is a tenth schematic partial top view of a back-contact photovoltaic module according to some embodiments of the present disclosure. The conductive block 203 has an upper side 203a and a lower side 203b along the first direction X. At least two insulating pads 224 are spaced apart and adjacent to one of the upper side 203a and the lower side 203b, and along the direction away from the conductive block 203, lengths of the at least two insulating pads 224 along the second direction Y progressively decrease. In other words, the at least two insulating pads 224, which are spaced apart along one of the two opposing sides of the conductive block 203 along the first direction X, are considered as one insulation structure group 254. Along the direction away from the conductive block 203, the lengths of the at least two insulating pads 224 along the second direction Y within a single insulation structure group 254 progressively decrease. That is, the farther an insulating pad 224 is from the conductive block 203, the shorter the insulating pad 224 is along the second direction Y.

Thus, based on variations in distance between the insulating pad and the conductive block 203, that is, variations in temperature during the process of welding the interconnecting member 205 to the conductive block 203 (referring to FIG. 17), the design of the insulating pad 224 farther away from the conductive block 203 has a smaller length along the second direction Y facilitates reducing the amount of the insulating material required for forming the insulating pad 224, which is conducive to lowering the preparation cost of the insulating member 204 and avoiding warping of the back-contact photovoltaic module caused by volume shrinkage of the insulating material covering a large area. In addition, such design also facilitates elevating more regions of the interconnecting member 205 with the plurality of insulating pads 224 disposed on the upper side 203a and the lower side 203b of the conductive block 203, so that bending of the interconnecting member 205 is mitigated, and the interconnecting member 205 is prevented from applying excessive stress to the cell substrate 200.

In some cases, at least two insulating pads 224 spaced apart and adjacent to one of the upper side 203a and the lower side 203b are considered as one insulation structure group 254. In a single insulation structure group 254, lengths of at least two insulating pads 224 along the second direction Y progressively decrease from 9 mm to 1 mm along the direction away from the conductive block 203.

For each of the insulating pads 224, in a case where the length of the insulating pad 224 along the second direction Y is less than 1 mm, the insulating pad 224 is relatively short, and the support strength of the insulating pad 224 for the interconnecting member 205 may be limited. When the interconnecting member 205 is placed on the conductive block 203 and connected, for example, welded to the conductive block 203, due to a small support area of the insulating pad 224 for the interconnecting member 205, the interconnecting member 205 is susceptible to instability, leading to relative displacement between the interconnecting member 205 and the conductive block 203. Moreover, the shorter insulating pad 224 provides a smaller stress buffer effect, which is prone to a large local stress exerted on the cell substrate 200 during welding. In a case where the length of the insulating pad 224 along the second direction Y is greater than 9 mm, the insulating pad 224 is relatively long, and the overall layout area of the insulating pad 224 on the cell substrate 200 is increased. This may affect the total layout area of the insulating member 204 on the cell substrate 200, which is not conducive to both reducing the volume of the insulating member 204 and preventing warping of the back-contact photovoltaic module.

In this way, in the direction away from the conductive block 203, the lengths of at least two insulating pads 224 along the second direction Y may progressively decrease from 9 mm to 1 mm. This design ensures that the insulating pads 224 adjacent to the conductive block 203 provide sufficient supporting strength for the interconnecting member 205 to achieve an excellent effect of stress buffering. As a result, relative displacement and stress concentration between the interconnecting member 205 and the conductive block 203 are effectively prevented. In addition, the insulating pads 224 farther from the conductive block 203 in the second direction Y is shorter, which effectively reduces the layout area of a single insulation structure group 254 on the cell substrate 200. This helps to prevent severe warping of the back-contact photovoltaic module, and reduce the preparation cost required for the insulation structure group 254.

The following provides detailed description of the design of thicknesses of a plurality of insulating members 204 along the third direction Z in a single first insulating group 214. The third direction Z is the thickness direction of the cell substrate 200.

In some embodiments, referring to FIG. 22, which is another schematic partial cross-sectional view of a back-contact photovoltaic module according to some embodiments of the present disclosure, along the direction away from the conductive block 203, the thickness of at least the insulating pad 224 farthest away from the conductive block 203 progressively decreases along the third direction Z.

In some other embodiments, referring to FIG. 21 and in combination with FIG. 23 which is a schematic partial cross-sectional view of a back-contact photovoltaic module according to some embodiments of the present disclosure, at least two insulating pads 224 spaced apart and adjacent to one of two opposing sides of the conductive block 203 along the first direction X is regarded as one insulation structure group 254, and in a single insulation structure group 254, along the direction away from the conductive block 203, the thicknesses of the at least two insulating pads 224 along the third direction Z progressively decrease.

In the above embodiments as illustrated in FIG. 22 or FIG. 23, in the direction away from the conductive block 203, the heights of the support points provided by the plurality of insulating pads 224 in a single insulation structure group 254 progressively decrease. This design helps to assist in gradual bending of the interconnecting member 205, and thus effectively prevents excessive bending in local areas of the interconnecting member 205. Therefore, it is conducive to reducing overall bending of the interconnecting member 205 along the third direction Z, thereby further reducing the risk of fracture of the adjacent busbar 202 and finger 201 due to significant stress applied by the interconnecting member 205 thereto. In addition, in the single insulation structure group 254, in the direction away from the conductive block 203, the thicknesses of at least two insulating pads 224 along the third direction Z progressively decrease. This design also helps to effectively reduce the overall amount of the insulating material required for a single insulation structure group 254, and thus prevents warping of the back-contact photovoltaic module caused by volume shrinkage of the insulating material covering a large area.

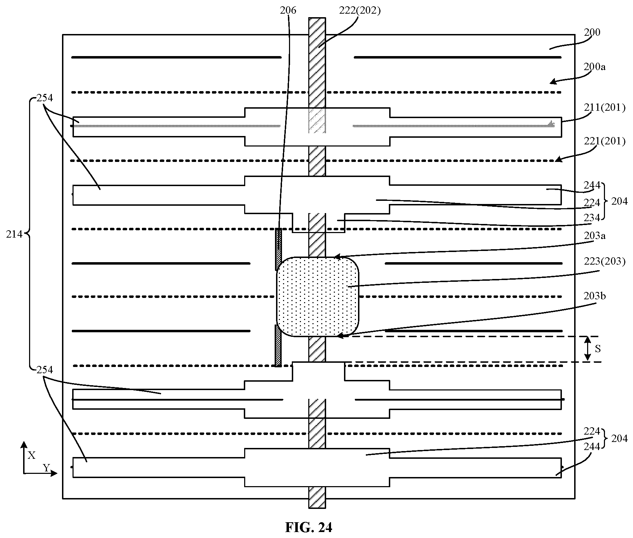

In some embodiments, referring to FIG. 24, FIG. 24 is an eleventh schematic partial top view diagram of a back-contact photovoltaic module according to some embodiments of the present disclosure. The back-contact photovoltaic module may further include at least one bridge finger 206 extending along the first direction X. One end of the bridge finger 206 is connected to a finger 201 disposed between the conductive block 203 and the insulating member 204, and the other end of the bridge finger 206 is connected to the conductive block 203.

It should be noted that the finger 201, disposed between the conductive block 203 and the insulating member 204 closest to the conductive block 203, is most affected by the solder paste 245 in the interconnecting member 205. In general, the finger 201 comes into contact with the busbar 202 electrically connected to the conductive block 203. However, due to the influence of the solder paste 245 (referring to FIG. 23) in the interconnecting member 205 (referring to FIG. 23), or the stress applied to the cell substrate 200 by the interconnecting member 205, a portion of the finger 201 adjacent to the insulating member 234 and not covered by the insulating member 234 may also be likely to fracture even if the extended portion 234 has covered a portion of the finger line 201. In this way, even if the portion of the finger 201 become inoperative for current transmission to the busbar 200 due to fracture, the current can still be transmitted through the bridge finger 206 to the conductive block 003. In other words, the design of the bridge finger 206 facilitates further ensuring that the interconnecting member 205 collects currents on all fingers 201 of the same polarity, e.g., all first fingers 211 or all second fingers 221, to improve the photovoltaic conversion efficiency of the back-contact photovoltaic module.

It should be noted that, FIG. 24 further illustrates a bridge finger 206 added to the structure illustrated in FIG. 21. In practice, a bridge finger may be added to the structure illustrated in FIG. 15, FIG. 16, or FIG. 19.

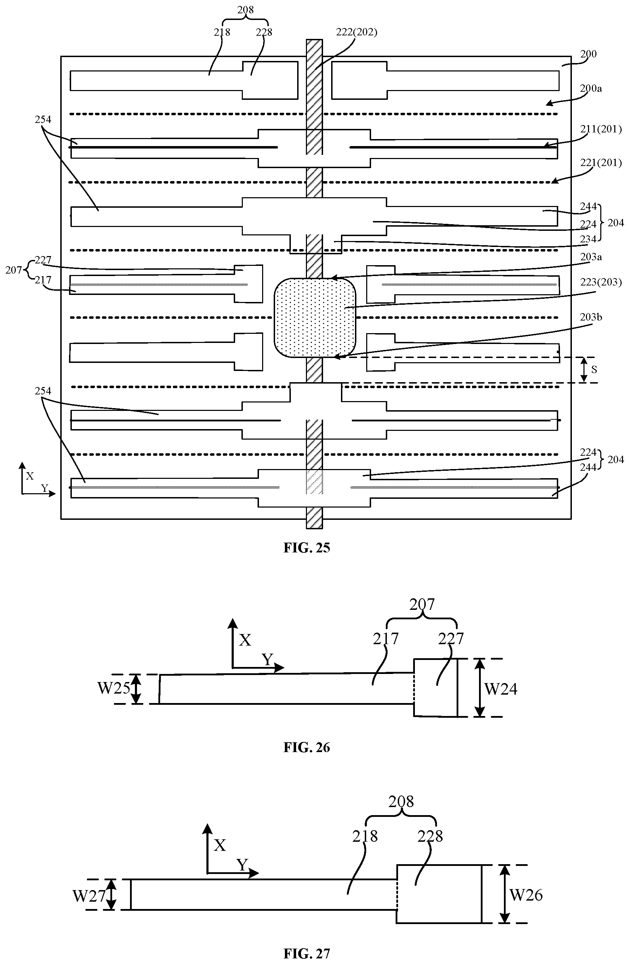

In some embodiments, as illustrated in FIG. 25, which is a twelfth schematic partial top view of a back-contact photovoltaic module according to some embodiments of the present disclosure, the back-contact photovoltaic module may further include a plurality of first insulating blocks 207 extending along the second direction Y. A single first insulating block 207 is disposed on one of two opposing sides of the conductive block 203 along the second direction Y, and covers at least a portion of one of two sections of the finger 201 disconnected by the conductive block 203. In other words, for a single conductive block 203, a first insulating block 207 is further arranged on a polarity-opposite finger 201 (i.e., a finger 201 electrically insulated from the conductive block 203) disposed on two opposing sides of the conductive block 203 along the second direction Y. The first insulating block 207 protects an end of the two sections of the finger 201 disconnected by the conductive block 203, so that an insulating material is present between the conductive block 203 and the portion of the finger 201. This further prevents the interconnecting member 205 from coming into contact with the finger 201 electrically insulated from the conductive block 203, and thus avoids the occurrence of short circuits in the back-contact photovoltaic module.

In some cases, along the second direction Y, the conductive block 203 is disposed between two adjacent first insulating blocks 207, and the number of fingers 201 disconnected by the conductive block 203 may be 2, or may be 1, 3, or 4. The number of fingers 201 to be disconnected maybe selected based on the actual size of the conductive block 203.

In some cases, referring to FIG. 25 and FIG. 26, FIG. 26 is a schematic cross-sectional view of a first insulating block in a back-contact photovoltaic module according to some embodiments of the present disclosure. The first insulating block 207 includes a first extended portion 217 and a first widened portion 227 adjacent to the conductive block 203. The first widened portion 227 covers an end of one of two sections of the finger 201 disconnected by the conductive block 203. The first extended portion 217 is disposed on a side of the first widened portion 227 away from the conductive block 203. Along the first direction X, the first widened portion 227 has a fourth width W24, and the first extended portion 217 has a fifth width W25. The fourth width W24 is greater than the fifth width W25. Thus, for each of the interconnecting members 205 and the conductive block 203 connected to the interconnecting member 205, not only is the interconnecting member 205 effectively prevented from coming into contact with the finger 201 electrically insulated from the conductive block 203 by virtue of the first widened portion 227, but also the protection for the finger 201 is enhanced by virtue of the first extended portion 217 having a smaller width than the first widened portion 227. In addition, the overall layout area of the first insulating block 207 on the cell substrate 200 is reduced as much as possible. This prevents warping of the back-contact photovoltaic module caused by volume shrinkage of the insulating material covering a large area.

It should be noted that in FIG. 26, the first extended portion 217 and the first widened portion 227 included in the first insulating sub-block 207 are delineated by dashed lines.

In some embodiments, referring to FIG. 25, the back-contact photovoltaic module may further include a plurality of second insulating blocks 208 spaced apart along the second direction Y. Each of the second insulating block 208 is disposed on a side of the insulating member 204 away from the conductive block 203. A single second insulating block 208 covers only at least a portion of one of two sections of one finger 201 disconnected by the busbar 202. In other words, for a single busbar 202, a second insulating block 208 is further arranged on a polarity-opposite finger 201 (i.e., a finger 201 electrically insulated from the busbar 202) disposed on two opposing sides of the busbar 202 along the second direction Y. The second insulating block 208 protects an end of the two sections of the finger 201 disconnected by the busbar 202, so that an insulating material is present between the busbar 202 and the portion of the finger 201. This further prevents the interconnecting member 205 from coming into contact with the finger 201 electrically insulated from the busbar 202, and thus avoids the occurrence of short circuits in the back-contact photovoltaic module.

In some cases, referring to FIG. 27, which is a schematic cross-sectional view of a second insulating block in a back-contact photovoltaic module according to some embodiments of the present disclosure. The second insulating block 208 includes a second extended portion 218 and a second widened portion 228 adjacent to the busbar 202. The second widened portion 228 covers an end of one of two sections of the finger 201 disconnected by the busbar 202. The second extended portion 218 is disposed on a side of the first widened portion 228 away from the busbar 202. Along the first direction X, the second widened portion 228 has a sixth width W26, and the second extended portion 218 has a seventh width W27. The sixth width W26 is greater than the seventh width W27. Thus, for each of the busbars 202 and the conductive block 203 connected to the busbar 202, not only is the busbar 202 effectively prevented from coming into contact with the finger 201 electrically insulated from the conductive block 203 by virtue of the second widened portion 228, but also the protection for the finger 201 is enhanced by virtue of the second extended portion 218 having a smaller width than the second widened portion 228. In addition, the overall layout area of the second insulating block 208 on the cell substrate 200 is reduced as much as possible. This prevents warping of the back-contact photovoltaic module caused by volume shrinkage of the insulating material covering a large area.

It should be noted that in FIG. 27, the second extension portion 218 and the second widened portion 228 included in the second insulating block 208 are delineated by dashed lines.

In some embodiments, along the first direction X, the fourth width W24 of the first widened portion 227 may be less than the sixth width W26 of the second widened portion 228. The first widened portion 227 is closer to the conductive block 203 than the second widened portion 228. By designing the fourth width W24 of the first widened portion 227 to be smaller, not only is the first insulating block 207 prevented from overflowing onto the conductive block 203, but also the overall layout area of the first insulating block 207 on the cell substrate 200 is reduced.

In some embodiments, along the second direction Y, the length of the first widened portion 227 may be less than the length of the second widened portion 228. The first widened portion 227 is closer to the conductive block 203 than the second widened portion 228. By designing the length of the first widened portion 227 to be smaller, not only is the first insulating block 207 prevented from overflowing onto the conductive block 203, but also the overall layout area of the first insulating block 207 on the cell substrate 200 is reduced.

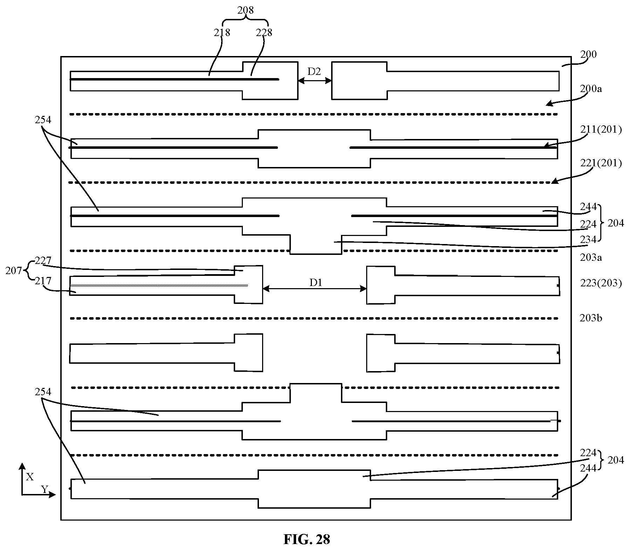

In some embodiments, referring to FIG. 28, which is a schematic partial top view of an insulating strip corresponding to a finger in a back-contact photovoltaic module according to some embodiments of the present disclosure, along the second direction Y, a spacing between two adjacent first insulating blocks 207 is a third spacing D3, and a spacing between two adjacent second insulating blocks 208 is a second spacing D2. The third spacing D3 is greater than the second spacing D2. Thus, compared with the extension length of the finger 201 disconnected by the conductive block 203 along the second direction Y, the extension length of the finger 201 disconnected by the busbar 202 along the second direction Y can be increased as large as possible under the protection of the second insulating block 208. This allows for the effective collection of photogenerated carriers in more regions on the cell substrate 200 by the finger 201, and the carriers are then collected by the interconnecting member 205, so that the photovoltaic conversion efficiency of the back-contact photovoltaic module is further enhanced.

It should be noted that the insulating strip in FIG. 28 includes, but is not limited to, the insulating member 204, the first insulating block 207, and the second insulating block.

In some examples, the third spacing D3 may be 1.3 mm, and the fourth spacing D4 may be 0.42 mm.

In some examples, along the first direction X, a plurality of fingers 201 are disconnected by the busbar 202. The fingers 201 adjacent to two opposing sides of the conductive block 203 along the first direction X are protected by the insulating member 204, while the fingers 201 away from the first insulating group 214 are protected by the second insulating blocks 208. Two adjacent second insulating blocks 208 disposed along the second direction Y on both sides of the busbar 202 are regarded as one third insulating group. A plurality of third insulating groups may be spaced apart along the first direction X, and the fourth spacing D4 between two adjacent second insulating blocks 208 in the plurality of third insulating groups may progressively increase to further reduce the total layout area of the second insulating blocks 208 on the cell substrate 200.

In some embodiments, the cell substrate 200 is a back-contact (BC) cell, which includes, but is not limited to, an interdigitated back-contact (IBC) cell, a heterojunction back-contact (HBC) cell, a TOPCon back-contact (TBC) cell, or a hybrid passivated back-contact (HPBC) cell. Further, the cell substrate 200 may be a full-cell or a split-cell, where the split-cell is formed by subjecting an intact full-cell to a dicing process.

In some embodiments, the back-contact photovoltaic module further includes an encapsulation layer. The encapsulation layer covers the surface of the cell substrate 200. The encapsulation layer may be made of a polyvinyl butyral (PVB) adhesive film, an ethylene-vinyl acetate (EVA) adhesive film, a polyethylene octene co-elastomer (POE) adhesive film, or a polyethylene terephthalate (PET) adhesive film. Alternatively, the encapsulation layer may also be an EP adhesive film, an EPE adhesive film, or a PVP adhesive film. The EP adhesive film refers to a co-extruded adhesive film formed by laminating an EVA adhesive film and a POE adhesive film, the EPE adhesive film refers to a co-extruded adhesive film formed by sequentially laminating an EVA adhesive film, a POE adhesive film, and an EVA adhesive film, and the PVP adhesive film refers to a co-extruded adhesive film formed by laminating a POE adhesive film, an EVA adhesive film, and a POE adhesive film. The method for preparing a co-extruded adhesive film may involve sequentially extruding one or more raw materials onto a pre-formed adhesive film, or bonding different types of pre-formed adhesive films together.

In some embodiments, the back-contact photovoltaic module further includes a cover plate, which is disposed on the surface of the encapsulation layer away from the cell substrate 200. The cover plate may be a glass cover plate, a plastic cover plate, or any other cover plate that has a light transmission function and is not easily damaged. In some embodiments, a surface of the cover plate facing the encapsulation layer may be a concave-convex surface or a textured surface including a plurality of protrusion structures, thereby increasing the utilization of incident light.

In summary, the design of the insulating member 204 including the insulating pad 224 not only ensures that the interconnecting member 205 subsequently connected to the conductive block 203 does not come into contact with a disconnected end of a polarity-opposite finger, thereby avoiding a short circuit between the first finger 211 and the second finger 221, but also ensures that higher support points are provided for the interconnecting member 205. This design allows the interconnecting member 205 to be supported by both the conductive block 203 and the insulating pad 224 along the second direction Y, which is conducive to increasing the overall elevated portion of the interconnecting member 205. On one hand, it is conducive to preventing excessive local bending of the interconnecting members 205, thereby reducing the risk that the interconnecting member 205 applies a large stress to the adjacent busbar 202 and finger 201, which could lead to fracture of the adjacent busbar 202 and finger 201. On the other hand, the insulating pad 224 covering the busbar 202 help to avoid that the molten material of the interconnecting member 205 drips on the busbar 202 under high-temperature conditions and causes fracture of the busbar 202, thereby further reducing the risk of fracture of the busbar 202. Moreover, at least one insulating member 204, disposed adjacent to the conductive block 203, is designed to further include an extended portion 234 protruding toward the conductive block 203. The extended portion 234 covers a portion of the finger 201 disposed between the conductive block 203 and the insulating member 204, which can effectively prevent fracture of the finger 201 at this position. Therefore, under the multifaceted effects of the insulating members 204, it is not only conductive to preventing short circuits between the first fingers 211 and the second fingers 221, as well as reducing the risk of fracture of the fingers 201 or the busbars 202, but also conductive to reduce the bending degree of the interconnecting members 205 so as to reduce the stress exerted by the interconnecting members 205 on the cell substrate 200 so that the structural stability of the back-contact photovoltaic module is significantly enhanced.

According to one aspect of the embodiments of the present disclosure, a back-contact photovoltaic module is provided. The back-contact photovoltaic module includes: a cell substrate, a plurality of conductive blocks, and a plurality of insulating members. First fingers and second fingers are alternatingly arranged on a back surface of the cell substrate. First busbars and second busbars are alternatingly arranged on the back surface of the cell substrate along a second direction. Each of the first fingers is disconnected at the second busbars, and each of the second fingers is disconnected at the first busbars. A respective conductive block is disposed at a disconnected position of a respective first finger and connected to a respective second busbar, or is disposed at a disconnected position of a respective second finger and connected to a respective first busbar. The plurality of insulating members extend along the second direction Y At least two insulating members serve as one first insulating group. Each respective first insulating group is provided for one respective conductive block. In the respective first insulating group, the at least two insulating members are respectively disposed on two opposing sides of the respective conductive block along the first direction X. Each insulating member at least includes an insulating pad covering a portion of a respective busbar connected to the conductive block and covering two ends of two sections of a finger disconnected by the respective busbar. The busbar is one of the first busbar and the second busbar, and the finger is one of the first finger and the second finger. Each of at least one insulating member adjacent to the conductive block further includes an extended portion protruding toward the conductive block, where the extended portion covers a portion of one finger disposed between the conductive block and the insulating member.

In some embodiments, the back-contact photovoltaic module further includes a plurality of interconnecting members spaced apart along the second direction. One respective interconnecting member is disposed on one respective busbar, and the respective interconnecting member is connected to at least the conductive block. The extended portion further covers a portion of the respective busbar connected to the conductive block, and with a plane defined by the first direction and the second direction as a reference plane, in the extended portion and the interconnecting member corresponding to a same busbar, an orthographic projection of the extended portion on the reference plane is overlapped with an orthographic projection of the interconnecting member on the reference plane.

In some embodiments, along the second direction, the extended portion has a first length, and the insulating pad has a second length, where a ratio of the first length to the second length ranges from 1:5 to 1:2.

In some embodiments, along the first direction, the extended portion has a first width, and the insulating pad has a second width, where a ratio of the first width to the second width ranges from 1:2 to 1:1.

In some embodiments, the conductive block has an upper side and a lower side along the first direction. An insulating member closest to the upper side and/or the lower side includes the insulating pad and the extended portion. Along the first direction, a spacing between the conductive block and the extended portion is greater than or equal to 0.20 mm.

In some embodiments, the respective insulating member at least includes the insulating pad and at least one extension member. A single extension member is connected to one of two opposite ends of the insulating pad along the second direction. Along the first direction, the insulating pad has a second width, and the extension member has a third width, where the second width is greater than the third width.

In some embodiments, the two opposing sides of the conductive block along the first direction are an upper side and a lower side. At least two insulating pads are spaced apart along a direction adjacent to one of the upper side and the lower side, and along a direction away from the conductive block, lengths of at least two insulating pads along the second direction progressively decrease.

In some embodiments, along a direction away from the conductive block, a thickness of at least the insulating pad farthest away from the conductive block along a third direction progressively decreases; and/or at least two insulating pads spaced apart and adjacent to one of two opposing sides of the conductive block along the first direction is regarded as one insulation structure group, and in a single insulation structure group, along a direction away from the conductive block, thicknesses of at least two insulating pads along a third direction progressively decrease. The third direction is a thickness direction of the cell substrate.

In some embodiments, the back-contact photovoltaic module further includes at least one bridge finger extending along the first direction, where one end of a respective bridge finger of the at least one bridge finger is connected to a finger disposed between the respective conductive block and the insulating member, and the other end of the respective bridge finger is connected to the respective conductive block.

In some embodiments, the back-contact photovoltaic module further include: a plurality of first insulating blocks extending along the second direction and/or a plurality of second insulating blocks extending along the second direction. A single first insulating block is disposed on one of two opposing sides of the conductive block along the second direction, and covers at least a portion of one of two sections of the finger disconnected by the conductive block. Each of the second insulating blocks is disposed on a side of the insulating member away from the conductive block, and a single second insulating block covers only at least a portion of one of two sections of the finger disconnected by the busbar.

Persons of ordinary skill in the art shall understand that the above embodiments are merely specific and exemplary embodiments for practicing the present disclosure, and in practice, various modifications may be made to these embodiments in terms of form and detail, without departing from the scope of the embodiments of the present disclosure. Various variations and modifications may be made by one skilled in the art without departing from the scope of the embodiments of the present disclosure. Accordingly, the protection scope of the embodiments of the present disclosure is subject to the appended claims.

## Claims

1. A back-contact photovoltaic module, comprising:
a cell substrate (100, 200);
a plurality of busbars (101, 202) and a plurality of fingers (102, 201) arranged on the cell substrate (100, 200), the plurality of fingers (102, 201) including first fingers (112, 211) and second fingers (122, 221) alternatingly arranged along a first direction (X), the plurality of busbars (101, 202) including first busbars (111, 212) and second busbars (121, 222) alternatingly arranged along a second direction (Y), each of the first fingers (112, 211) and second fingers (122, 221) including a plurality of disconnected sections, wherein each first busbar (111, 212) of at least some of the first busbars (111, 212) is between respective two adjacent disconnected sections of each of the second fingers (122, 221), and each second busbar (121, 222) of at least some of the second busbars (121, 222) is between respective two adjacent disconnected sections of each of the first fingers (112, 211);
a plurality of conductive blocks (103, 203), wherein a respective conductive block (103, 203) of the plurality of conductive blocks (103, 203) is disposed between two adjacent disconnected sections of each of one or more first fingers (112, 211) of the first fingers (112, 211) and connected to a respective second busbar (121, 222) of the at least some of the second busbars (121, 222), or is disposed between two adjacent disconnected sections of each of one or more second fingers (122, 221) of the second fingers (122, 221) and connected to a respective first busbar (111, 212) of the at least some of the first busbars (111, 212); and
insulating members (104, 204) extending along the second direction (Y), including two insulating members (104, 204) respectively disposed on two opposing sides of the respective conductive block (103, 203), each respective insulating member (104, 204) of the two insulating members (104, 204) including an insulating pad (114, 224) and at least one extension member (124, 244), and each respective extension member (124, 244) of the at least one extension member(124, 244) extending in the second direction (Y) and having an end connected to one respective end of two opposite ends of the insulating pad (114, 224);
wherein the insulating pad (114, 224) at least covers a portion of a respective busbar (101, 202) connected to the respective conductive block (103, 203), the respective extension member(124, 244) covers at least a portion of a section of a respective finger (102, 201) on one side of the respective busbar (101, 202) and disconnected from an adjacent section of the respective finger (102, 201) on an opposite side of the respective busbar (101, 202), and along the first direction (X), a first width (W1, W22) of the insulating pad (114, 224) is greater than a second width (W2, W23) of the respective extension member(124, 244).

2. The back-contact photovoltaic module according to claim 1, wherein the insulating pad (114, 224) further covers at least one end of two sections of the respective finger (102, 201) disconnected by the respective busbar (101, 202).

3. The back-contact photovoltaic module according to any one of claims 1 to 2, wherein along a third direction (Z), a first thickness of the insulating pad (114, 224) is greater than a second thickness of the respective extension member(124, 244), wherein the third direction (Z) is a thickness direction of a body of the cell substrate (100, 200).

4. The back-contact photovoltaic module according to any one of claims 1 to 3, further comprising:
at least one bridge finger (105, 206), extending along the first direction (X), wherein one end of each respective bridge finger (105, 206) of the at least one bridge finger (105, 206) is connected to a respective finger (102, 201) disposed between the respective conductive block (103, 203) and the respective insulating member (104, 204), and another end of the respective bridge finger (105, 206) is connected to the respective conductive block (103, 203).

5. The back-contact photovoltaic module according to any one of claims 1 to 4, wherein the insulating members (104, 204) include an insulating member (104, 204) that is adjacent to the respective conductive block (103, 203) and further includes an extended portion (134, 234) protruding toward the respective conductive block (103, 203), wherein the extended portion (134, 234) covers a portion of a respective finger (102, 201) disposed between the respective conductive block (103, 203) and the respective insulating member (104, 204).

6. The back-contact photovoltaic module according to claim 5, wherein the extended portion (134, 234) has a first length (L1, L21) along the second direction (Y), the insulating pad (114, 224) of the insulating member (104, 204) has a second length (L1, L22) along the second direction (Y), and a ratio of the first length (L1, L21) to the second length (L1, L21) is 1:5 to 1:2; optionally, the first length (L1, L21) is greater than or equal to 0.20 mm, and the second length (L1, L21) is 1 mm to 9 mm.

7. The back-contact photovoltaic module according to claim 5, wherein the extended portion (L1, L21) has a third width (W3, W21) along the first direction (X), and a ratio of the third width (W3, W21) to the first width (W1, W22) is 1:2 to 1:1; optionally, the third width (W3, W21) is 0.2 mm to 0.3 mm, and the first width (W1, W22) is 0.3 mm to 0.5 mm.

8. The back-contact photovoltaic module according to claim 5, wherein the respective conductive block (103, 203) has opposing upper and lower sides, a respective insulating member (104, 204) closest to at least one of the upper and lower sides of the respective conductive block (103, 203) includes the insulating pad (114, 224) and the extended portion (L1, L21), and along the first direction (X), a spacing between the respective conductive block (103, 203) and the extended portion (L1, L21) is greater than or equal to 0.20 mm.

9. The back-contact photovoltaic module according to claim 5, further comprising:
a plurality of interconnecting members (106, 205), spaced apart along the second direction (Y), wherein each respective interconnecting member (106, 205) of the plurality of interconnecting members (106, 205) is disposed on the respective busbar (101, 202), and the respective interconnecting member (106, 205) is connected to at least the respective conductive block (103, 203);
wherein the extended portion (L1, L21) further covers a portion of the respective busbar (101, 202) connected to the respective conductive block (103, 203), and on a reference plane defined by the first direction (X) and the second direction (Y), an orthographic projection of the extended portion (L1, L21) is overlapped with an orthographic projection of the respective interconnecting member (106, 205).

10. The back-contact photovoltaic module according to any one of claims 1 to 9, wherein the respective conductive block (103, 203) has opposing upper and lower sides, and
wherein at least two insulating pads (114, 224) are spaced apart and disposed adjacent to one of the upper and lower sides, and along a direction away from the respective conductive block (103, 203), lengths of the at least two insulating pads (114, 224) along the second direction (Y) progressively decrease.

11. The back-contact photovoltaic module according to any one of claims 1 to 10, wherein along a direction away from the respective conductive block (103, 203), a thickness of at least an insulating pad (114, 224) farthest away from the respective conductive block (103, 203) along a third direction (Z) progressively decreases, wherein the third direction (Z) is a thickness direction of a body of the cell substrate (100, 200).

12. The back-contact photovoltaic module according to any one of claims 1 to 11, further comprising:
at least two first insulating blocks (107) spaced apart along the first direction (X), wherein each respective first insulating block (107) of the at least two first insulating blocks (107) includes two first insulating sub-blocks (117) spaced apart along the second direction (Y), wherein each of the two first insulating sub-blocks (117) is disposed on a respective side of two opposing sides of the respective conductive block (103) along the second direction (Y), and covers only at least a portion of a respective one of two sections of the respective finger (102) disconnected by the respective conductive block (103).

13. The back-contact photovoltaic module according to any one of claims 1 to 12, further comprising:
at least two second insulating blocks (108) spaced apart along the first direction (X), wherein each of the second insulating blocks (108) includes two second insulating sub-blocks (118) spaced apart along the second direction (Y), wherein a single second insulating sub-block (118) covers only at least a portion of one of two sections of the finger disconnected by the busbar (101, 202); optionally, along the second direction (Y), a spacing (D1) between the two first insulating sub-blocks (117) is greater than a spacing (D2) between the two second insulating sub-blocks (118).

14. The back-contact photovoltaic module according to any one of claims 1 to 13, wherein the insulating member (104, 204) includes two extension members (124, 244) respectively connected to two opposite ends of the insulating pad (114, 224) along the second direction (Y); optionally, along a direction away from the respective busbar (101, 202), a second thickness of the respective extension member (124, 244) along a third direction (Z) progressively decreases, wherein the third direction (Z) is a thickness direction of a body of the cell substrate (100, 200).

15. The back-contact photovoltaic module according to any one of claims 1 to 13, wherein thicknesses of the at least two insulating pads (114, 224) along a third direction (Z) progressively decrease, wherein the third direction (Z) is a thickness direction of a body of the cell substrate (100, 200).
